(19) Europäisches Patentamt / European Patent Office / Office européen des brevets

(11) **EP 1 683 278 B1**

(12) **EUROPÄISCHE PATENTSCHRIFT**

(45) Veröffentlichungstag und Bekanntmachung des Hinweises auf die Patenterteilung:
**08.07.2009 Patentblatt 2009/28**

(21) Anmeldenummer: **04791099.7**

(22) Anmeldetag: **28.10.2004**

(51) Int Cl.:
**H04B 5/00** *(2006.01)* **H01L 23/48** *(2006.01)*

(86) Internationale Anmeldenummer:
**PCT/EP2004/012351**

(87) Internationale Veröffentlichungsnummer:
**WO 2005/043482 (12.05.2005 Gazette 2005/19)**

(54) **PROZESSORBAUSTEIN ZUR KONTAKTLOSEN SIGNALÜBERTRAGUNG**

PROCESSOR COMPONENT FOR CONTACTLESS SIGNAL TRANSMISSION

MODULE PROCESSEUR POUR LA TRANSMISSION DE SIGNAUX SANS CONTACT

(84) Benannte Vertragsstaaten:
**AT BE BG CH CY CZ DE DK EE ES FI FR GB GR HU IE IT LI LU MC NL PL PT RO SE SI SK TR**

(30) Priorität: **31.10.2003 DE 10351719**

(43) Veröffentlichungstag der Anmeldung:
**26.07.2006 Patentblatt 2006/30**

(73) Patentinhaber: **IHP GmbH-Innovations for High Performance Microelectronics/Institut für innovative Mikroelektronik 15236 Frankfurt an der Oder (DE)**

(72) Erfinder: **GUSTAT, Hans 15752 Prieros (DE)**

(74) Vertreter: **Eisenführ, Speiser & Partner Patentanwälte Rechtsanwälte Spreepalais am Dom Anna-Louisa-Karsch-Strasse 2 10178 Berlin (DE)**

(56) Entgegenhaltungen:
**WO-A1-20/04012265**

• **DROST R J ET AL: "Proximity communication" PROCEEDINGS OF THE IEEE 2003 CUSTOM INTEGRATED CIRCUITS CONFERENCE. (CICC 2003). SAN JOSE, CA, SEPT. 21 - 24, 2003, IEEE CUSTOM INTEGRATED CIRCUITS CONFERENCE.CICC, NEW YORK, NY : IEEE, US, Bd. CONF. 25, 21. September 2003 (2003-09-21), Seiten 469-472, XP010671070 ISBN: 0-7803-7842-3**
• **KANDA K ET AL: "1.27Gb/s/pin 3mW/pin wireless superconnect (WSC) interface scheme" SOLID-STATE CIRCUITS CONFERENCE, 2003. DIGEST OF TECHNICAL PAPERS. ISSCC. 2003 IEEE INTERNATIONAL SAN FRANCISCO, CA, USA 9-13 FEB. 2003, PISCATAWAY, NJ, USA,IEEE, US, 9. Februar 2003 (2003-02-09), Seiten 1-10, XP010661608 ISBN: 0-7803-7707-9 in der Anmeldung erwähnt**
• **MICK S ET AL: "4 Gbps high-density AC coupled interconnection" PROCEEDINGS OF THE IEEE 2002 CUSTOM INTEGRATED CIRCUITS CONFERENCE (CAT. NO.02CH37285) IEEE PISCATAWAY, NJ, USA, 12. Mai 2002 (2002-05-12), Seiten 133-140, XP002316058 ISBN: 0-7803-7250-6 in der Anmeldung erwähnt**

EP 1 683 278 B1

**Beschreibung**

Die Erfindung betrifft eine Chip-Anordnung und ein Verfahren zur kontaktlosen Kopplung eines ersten und eines zweiten Chips miteinander.

Die Anforderungen an die Verbindungstechnik elektronischer Baugruppen erhöhen sich durch steigende Taktraten. Ein Beispiel mit sehr großer Bedeutung ist die Kommunikation zwischen einem Prozessor und einem Hauptspeicher bei Computern. Die Schnittstelle zwischen Prozessor und Hauptspeicher bildet den wesentlichen Engpass für das Wachstum der Rechenleistung des Systems. In absehbarer Zeit sind 64-bit-Prozessoren mit einer Taktrate von etwa 5 GHz zu erwarten. Diese könnten eine Schnittstelle zu einem Hauptspeicher mit einer Datenrate von bis zu 320 Gbit/s bedienen.

Eine Lösung zur Bewältigung solch hoher Datenraten wäre es, den internen Cache-Speicher des Prozessors soweit zu vergrößern, dass zumindest während der Ausführung eines Threads stets ausreichend Speicherplatz vorhanden ist, insbesondere ein Block für zusammenhängenden Code üblicher Größe. Hierbei dürfte es sich in naher Zukunft um zusammenhängende Segmente von einigen 10 MB handeln. Ein großer interner Cache wird wegen der technologischen Anforderungen für Speicher auf einem Chip mit einer CPU nicht flächenoptimal sein. Zudem verringert die Fläche des Speichers die Ausbeute des gesamten Prozessors beträchtlich.

Eine alternative Lösung besteht darin, einen genügend leistungsfähigen Datenpfad zu externem schnellen Speicher, beispielsweise in Form von SRAM (static random access memory) zu schaffen. Aus der US 6,496,889 B1 ist eine Chip-Anordnung bekannt, bei der Signale von einem ersten Chip zu einem zweiten Chip mit Hilfe einer kapazitiven Kopplung über einen Hochgeschwindigkeits-Datenbus bewirkt wird. Hierzu wird das Gehäuse, in dem der erste bzw. zweite Chip untergebracht ist, am Gehäuseboden mit Kopplungselementen in Form metallisch leitfähiger Streifen versehen. Das Gehäuse wird auf ein Substrat aufgesetzt, das einen kapazitiv koppelbaren Datenbus aufweist. Das Substrat weist zur Ein- und Auskopplung des Signals an den Schnittstellen mit dem ersten und zweiten Chip ebenfalls metallische Streifen auf. Auf diese Weise lassen sich mehrere IC-Bausteine auf dem Substrat anordnen und miteinander koppeln.

Ein Nachteil der aus der US 6,496,889 B1 bekannten Lösung ist die Kopplung der Chips über ein Signal-Substrat, das als zugleich Träger für die Chips und als Datenbus dient. Diese Technik bedingt zusätzliche Kosten für die Herstellung des Trägers. Das Signal-Substrat selbst stellt nämlich relativ hohe Anforderungen an die Fertigungsgenauigkeit, so dass es mit einer Technologie gefertigt werden muss, die nahe am Niveau einer Halbleitertechnologie ist. Der Flächenpreis für ein solches Signal-Substrat ist also relativ hoch.

Aus dem Dokument K. Kanda, D. D. Antono, K. Ishida, H. Kawaguchi, T. Kuroda, and T. Sakurai, "1.27-Gbps/pin, 3mW/pin Wireless Superconnect (WSC) Interface Scheme," IEEE ISSCC Digest of Technical Papers, Feb. 2003, pp. 186-187 ist eine Chip-Anordnung bekannt, bei der Chips übereinander angeordnet werden. Ein erster Chip weist auf der gesamten Fläche seiner Unterseite verteilte und ein zweiter Chip auf der gesamten Fläche seiner Oberseite verteilte Kopplungsflächen, so genannte Mini-Pads auf. Die Mini-Pads sind etwa quadratisch mit einer Seitenlänge von 20 $\mu$m. Ihr Abstand voneinander beträgt ebenfalls 20 $\mu$m. Die Chips werden so zu einander angeordnet, dass zwischen einander zugeordneten Mini-Pads eine kapazitive Kopplung entsteht. Dazu werden die Chips aufeinander so gelegt, dass einander zugeordnete Kopplungsflächen auf einander liegen. Zur Herstellung der kapazitiven Kopplung werden die zugeordneten Pads mit einem Abstand von 1 bis 2 $\mu$m zueinander angeordnet. Die Oberfläche der Mini-Pads ist mit einer Oxidschicht versehen. Auf diese Weise kann auf weitere Strukturen zum Schutz vor elektrostatischer Entladung (electrostatic discharge, ESD) verzichtet werden. So wird die Kapazität eines Paares von Pads verringert, was die Signalübertragung verbessert. Eine Datenrate von 1,27 Gbit/s pro Pad bei 3 mW Verlustleistung wurde erreicht.

Nachteil der vorbekannten Chip-Anordnungen ist die Schwierigkeit, eine exakte Positionierung der Chips zueinander zu bewerkstelligen. Auch Ungenauigkeiten der Fertigung sowie Erwärmung eines Chips beim Betrieb führen zu Fehlern der Position der Mini-Pads relativ zueinander.

Gerade für Prozessoren muss die thermische Belastbarkeit jedoch sehr hoch sein. Um eine ausreichende Kopplung zu gewährleisten, bedingt dies hohe Mindestwerte für die Größe der Elektroden. Große Elektroden begrenzen die Datenrate durch kapazitive Belastung des Signalweges und durch eine Verringerung der Zahl der möglichen Datenpfade.

Weiterhin nehmen relativ große Pads einen großen Teil der zur Verfügung stehenden Chip-Fläche für die kontaktlose Kopplung ein. Dadurch wird der mechanische Aufbau des Chips im Gehäuse von der kontaktlosen Kopplung dominiert. Insbesondere bei Prozessoren wird ein großer Anteil der Chip-Fläche in aller Regel für herkömmliche Verbindungen sowie für die Kühlung benötigt. Daher ist das Vorsehen beispielsweise einer zusätzlichen kontaktlosen Kopplung zum Hauptspeicher-Chip mit den herkömmlichen Flächenanforderungen nicht kompatibel. Die kontaktlose Kopplung zusätzlich zu konventionellen Verbindungstechniken zur Signalübertragung ist daher im Prozessorbereich nicht einsetzbar.

Tatsächlich sehen weitere vorbekannte Lösungen daher vor, eine kapazitive Kopplung als vollständigen Ersatz bisheriger Verbindungstechniken einzusetzen. Vgl. hierzu D.B. Salzman, T.F. Knight, "Capacitively Coupled Multichip Modules," Proceedings of the 1994 International Conference on Multichip Modules, April 1994, pp. 487-494, oder D. Salzman, T. Knight, "Capacitive coupling solves the known good die problem," Proceedings of the 1994 Multi-Chip Module Conference, 1994, pp. 95-100, oder D.B. Salzman, T.F. Knight, "Manufacturability of capacitively coupled multichip modules," IEEE Transactions onComponents, Packaging, and Manufacturing Technology, Part B: Advanced Packaging, vol. 18, no. 2, May 1995, pp. 277-281, oder D. Salzman, T. Knight, P. Franzon, "Application of capacitive coupling to switch fabrics," Proceedings of the 1995 Multi-Chip Module Conference, 1995, pp. 195 -199, oder S. Mick, J. Wilson and P. Franzon, "4 Gbps High-Density AC Coupled Interconnection", IEEE 2002 CICC Digest of Technical Papers, May 2002, oder K. Kanda, D. D. Antono, K. Ishida, H. Kawaguchi, T. Kuroda, and T. Sakurai, "1.27-Gbps/pin, 3mW/pin Wireless Superconnect (WSC) Interface Scheme," IEEE ISSCC Digest of Technical Papers, Feb. 2003, pp. 186-187.

Aus der Veröffentlichung von Robert J. Drost et al.: "Proximity Communication", Proceedings of IEEE 2003, pp. 469-472, ist eine Anordnung von zwei Chips bekannt, die kontaktlos miteinander gekoppelt sind. Die Kopplung erfolgt kapazitiv, wobei die beiden Chips jeweils genau die gleiche Anzahl von Kopplungselementen für die Kopplung beider Chips miteinander aufweisen. Als kritisch wird dabei die notwendigerweise genaue Positionierung der beiden Chips zueinander angesehen. Im Test wurde zwischen den Chips eine Übertragungsrate von 21,6 Gigabit je Sekunde erzielt.

Aufgabe der vorliegenden Erfindung ist es, eine Chip-Anordnung anzugeben, die die genannten Nachteile nicht aufweist, die insbesondere eine Vereinfachung der horizontalen Positionierung der Chips ermöglicht.

Die Aufgabe wird gelöst durch eine Chip-Anordnung gemäß Anspruch 1 oder 2, sowie durch ein Verfahren zur Herstellung einer Chip-Anordnung gemäß Anspruch 29.

Bevorzugte Ausführungsformen der Erfindung sind in den abhängigen Ansprüchen angegeben.

Gemäß einem ersten Aspekt der Erfindung wird die Aufgabe gelöst durch eine Chip-Anordnung mit einem ersten Chip, der mindestens eine erste Signalschnittstelle mit längs einer ersten Linie in einer ersten Anzahldichte angeordneten ersten Kopplungselementen aufweist, und mit mindestens einem zweiten Chip, der mindestens eine zweite Signalschnittstelle mit längs einer zweiten Linie in einer zweiten Anzahldichte angeordneten zweiten Kopplungselementen aufweist,

- bei der die erste Signalschnittstelle längs einer Kante des ersten Chips und die zweite Signalschnittstelle längs einer Kante des zweiten Chips vorgesehen ist,
- bei der die ersten und zweiten Kopplungselemente ausgebildet sind, eine kontaktlose Signalübertragung zwischen der ersten und der zweiten Signalschnittstelle zu ermöglichen,
- bei der der erste und der zweite Chip relativ zueinander so angeordnet sind, dass Kopplungselemente der ersten und der zweiten Signalschnittstelle miteinander kontaktlos Signale übertragen können, wobei die genannten Kanten des ersten und zweiten Chips einander zugewandt angeordnet sind, dadurch gekennzeichnet, dass

- die Längserstreckung mindestens einer der Signalschnittstellen längs der ihr zugeordneten Linie größer ist als die Länge der Überlappung beider Längserstreckungen, wobei diese Überlappung die Strecke ist, die die Projektion der ersten Längserstreckung auf die zweite Längserstreckung gemeinsam hat mit der zweiten Längserstreckung,
- und dass eine der Signalschnittstellen eine größere Anzahldichte an Kopplungselementen aufweist als die andere.

Gemäß einem zweiten Aspekt der Erfindung wird die Aufgabe gelöst durch eine Chip-Anordnung mit einem ersten Chip, der mindestens eine erste Signalschnittstelle mit längs einer ersten Linie in einer ersten Anzahldichte angeordneten ersten Kopplungselementen aufweist, und mit mindestens einem zweiten Chip, der mindestens eine zweite Signalschnittstelle mit längs einer zweiten Linie in einer zweiten Anzahldichte angeordneten zweiten Kopplungselementen aufweist,

- bei der die erste Signalschnittstelle längs einer Kante des ersten Chips und die zweite Signalschnittstelle längs einer Kante des zweiten Chips vorgesehen ist,
- bei der die ersten, zweiten und dritten und vierten Kopplungselemente ausgebildet sind, eine kontaktlose Signalübertragung zwischen der ersten und der zweiten Signalschnittstelle zu ermöglichen,

gekennzeichnet durch einen Kopplungsbaustein, der auf einem Substrat eine Kopplungseinheit mit längs einer dritten Linie in einer dritten Anzahldichte angeordneten dritten Kopplungselementen sowie mit längs einer vierten Linie in einer vierten Anzahldichte angeordneten vierten Kopplungselementen aufweist, wobei die dritten Kopplungselemente jeweils mit den vierten Kopplungselementen elektrisch leitend verbunden sind,

- bei der der erste und der zweite Chip sowie der Kopplungsbaustein so zueinander angeordnet sind, dass dritte Kopplungselemente der Kopplungseinheit und erste Kopplungselemente der ersten Signalschnittstelle sowie vierte Kopplungselemente der Kopplungseinheit und zweite Kopplungselemente der zweiten Signalschnittstelle jeweils miteinander kontaktlos Signale übertragen können, wobei die genannten Kanten des ersten und zweiten Chips einander zugewandt angeordnet sind,
- bei der für die Längserstreckungen jeweils der ersten und dritten Kopplungselemente in Abstandsrichtung der Kopplungselemente längs der ihr zugeordneten Linie gilt, dass mindestens eine der Längserstreckungen größer ist als die Länge der Überlappung beider Längserstreckungen,

- bei der für die Längserstreckungen jeweils der zweiten und vierten Kopplungselemente in Abstandsrichtung der Kopplungselemente längs der ihr zugeordneten Linie gilt, dass mindestens eine der Längserstreckungen größer ist als die Länge der Überlappung beider Längserstreckungen,
- und bei der der Kopplungsbaustein eine größere Anzahldichte an Kopplungselementen aufweist als die erste oder die zweite Signalschnittstelle oder als die erste und die zweite Signalschnittstelle.

Die Chip-Anordnungen gemäß dem ersten und dem zweiten Aspekt der Erfindung gehen von dem Ansatz aus, Chips mit einem sehr breiten Datenbus, d.h. weit über 100 Signale, mit sehr hoher Anzahldichte, d.h. mindesten 40 Signale pro Millimeter der Längserstreckung der Signalschnittstelle, für die Signalübertragung zu koppeln, ohne dafür eine laterale Positionierung mit Genauigkeiten von 25 μm oder darunter zu benötigen. Vielmehr kann die Positionierung sogar deutlich ungenauer sein als das Rastermaß, also der Kehrwert der Anzahldichte. Außerdem soll zur Verbindung für diesen Datenbus kein großflächiges Signal-Substrat mit hoher Anzahldichte benötigt werden, sondern entweder gar kein signalführender Baustein zusätzlich zu den Chips, oder ein Kopplungsbaustein mit einer Kopplungseinheit, welche eine kleinere Fläche hat als die Chipflächen. Auf diese Weise können die Herstellungskosten der erfindungsgemäßen Chip-Anordnungen im Vergleich mit bekannten Lösungen gering gehalten werden.

Die erfindungsgemäße Lösung ermöglicht eine besonders einfache Positionierung bei der Herstellung der Chip-Anordnung kontaktlosen Signalübertragung. Gleichzeitig kann mit der erfindungsgemäßen Lösung eine hohe Dichte von Kopplungselementen erzielt werden, die einen geringen Flächenbedarf auf dem Chip beansprucht. Damit kann die erfindungsgemäße Anordnung neben einer kontaktlosen Signalübertragung zwischen dem ersten und zweiten Chip auch konventionelle Verbindungstechniken aufweisen.

Die erfindungsgemäße Lösung fußt auf folgenden Überlegungen: Damit eine Kopplung zwischen der ersten und zweiten Signalschnittstelle für die kontaktlose Signalübertragung auf einfache Weise sicher erfolgen kann, weist eine der Signalschnittstellen eine größere Anzahldichte an Kopplungselementen auf als die andere und hat eine der Signalschnittstellen eine größere Längserstreckung als die Überlappung beider Längserstreckungen. Bringt man die Signalschnittstellen des ersten und des zweiten Chips in eine solche Überlappung, so erlaubt die erfindungsgemäße Lösung eine gewisse, für die Praxis wesentliche Unschärfe bei der Positionierung der Signalschnittstellen relativ zueinander. Die höhere Anzahldichte an Kopplungselementen auf einem Chip gestattet eine Anordnung der Signalschnittstellen relativ zueinander, bei der die Zuordnung der ersten und zweiten Kopplungselemente nicht vorbestimmt ist. Die höhere Anzahldichte an Kopplungselementen sollte vorzugsweise so gewählt sein, dass bei jedem möglichen Versatz der Signalschnittstellen zueinander dennoch immer mindestens ein, vorzugsweise mehrere Kopplungselemente der Signalschnittstelle mit höherer Dichte eine Kopplung zu einem Kopplungselement der Signalschnittstelle mit geringerer Anzahldichte an Kopplungselementen aufweist. Es muss bei der erfindungsgemäßen Chip-Anordnung nicht mehr ein bestimmtes Kopplungselement des zweiten Chips in Übereinstimmung mit einem bestimmten Kopplungselement des zweiten Chips gebracht werden. Diese Maßnahme schafft eine hohe Toleranz bei der Positionierung der ersten und zweiten Kopplungselemente relativ zu einander in der Abstandsrichtung.

Der Einfachheit der Darstellung halber wird nachfolgend angenommen, dass die zweite Signalschnittstelle eine größere Anzahldichte an Kopplungselementen aufweist als die erste. Es versteht sich, dass die Betrachtungen ebenso bei umgekehrten Verhältnissen gelten. Beispielsweise kann der Abstand zwischen zwei zweiten Kopplungselementen kleiner gewählt werden als die Breitenerstreckung eines ersten Kopplungselementes in der Abstandsrichtung der zweiten Kopplungselemente. Um bei der Positionierung der Signalschnittstellen relativ zueinander genügend Spielraum zu haben, ist erfindungsgemäß eine der Signalschnittstellen in Längsrichtung, das heißt längs der Linie, entlang der die Kopplungselemente angeordnet sind, größer als die Überlappung beider Längserstreckungen. Beispielsweise kann hierfür die eine Längserstreckung größer sein als die andere. Vorzugsweise ist dabei die Signalschnittstelle, welche eine größere Anzahldichte an Kopplungselementen aufweist, auch diejenige, welche eine höhere Längserstreckung hat.

Dabei kommt es für den Erfolg der kontaktlosen Kopplung zwischen dem ersten und dem zweiten Chip nicht darauf an, ob ein zweites Kopplungselement oder ob mehrere zweite Kopplungselemente mit einem ersten Kopplungselement gekoppelt werden. Es genügt, dass beliebige, im allgemeinen mehrere zweite Kopplungselemente jeweils einem ersten Kopplungselement zugeordnet sind. Eine kontaktlose Signalübertragung kann also zwischen auf der einen Seite je einem ersten Kopplungselement der ersten Signalschnittstelle und auf der anderen Seite mindestens einem zweiten Kopplungselement, alternativ mindestens zwei zweiten Kopplungselementen, alternativ zum Teil einem zweiten Kopplungselement und zum Teil mindestens zwei zweiten Kopplungselementen der zweiten Signalschnittstelle erfolgen.

Weiterhin können die zweiten Kopplungselemente in ihrer Breitenerstreckung in der Abstandsrichtung schmaler ausgebildet sein als der Abstand zwischen den ersten Kopplungselementen. Damit wird sichergestellt, dass die zweiten Kopplungselemente keine Kopplung zwischen benachbarten ersten Kopplungselementen ein und desselben Chips bewirken.

Bei der erfindungsgemäßen Chip-Anordnung ist es aufgrund dieser Verhältnisse nicht mehr wichtig, welches zweite Kopplungselement mit welchem ersten Kopplungselement koppelt, solange nur überhaupt hinreichend viele Kopplungselemente der ersten und der zweiten Signalschnittstelle jeweils miteinander koppeln, um die gewünschte Breite des Datenbusses zu erreichen. Eine Zuordnung der von den Kopplungselementen übertragenen Signale zu den Signalen des Datenbusses, ggf. außerdem mit einer Trennung der Signale durch Signalverarbeitung, wird mit Hilfe zusätzlicher Baugruppen, die auf mindestens einem der Chips vorhanden sind, ermöglicht.

Die erfindungsgemäße Chip-Anordnung zeichnet sich daher durch eine einfache und dabei hinreichend präzise Positionierbarkeit ihrer Komponenten relativ zueinander aus. Die Positionierbarkeit ist vor allem in Abstandsrichtung der Kopplungselemente gegenüber vorbekannten Lösungen vereinfacht. Dies ist insbesondere von Bedeutung, weil die ersten und zweiten Kopplungselemente besonders schmal und dicht in Mikrometer-Größenordnungen ausgebildet sein können. Solche Dimensionen erfordern normalerweise hoch präzise Positionierungswerkzeuge. Dagegen bietet die Erfindung eine ganz wesentliche Erleichterung der Positionierung der Chips einer Chip-Anordnung. Ein hoher maschineller Aufwand für die Positionierung ist daher verzichtbar.

Bei der Chip-Anordnung gemäß dem ersten Aspekt der vorliegenden Erfindung können der erste und der zweite Chip ohne Schwierigkeit so zueinander angeordnet werden, dass eine kontaktlose Signalübertragung zwischen je einem ersten Kopplungselement und mindestens einem zweiten Kopplungselement erfolgen kann. Die Kopplung erfolgt direkt, ohne Vermittlung eines Signal-Substrats oder dergleichen.

Bei der Chip-Anordnung gemäß dem zweiten Aspekt der Erfindung ist ein erfindungsgemäßer Kopplungsbaustein Träger der dritten und vierten Kopplungselemente. Der erste und der zweite Chip weisen zur Kopplung miteinander über den Kopplungsbaustein eine erste bzw. eine zweite Signalschnittstelle auf. Bei dem Kopplungsbaustein weist die Kopplungseinheit eine größere Anzahldichte an Kopplungselementen auf als die erste oder die zweite Signalschnittstelle oder als die erste und die zweite Signalschnittstelle. Weiterhin hat die Kopplungseinheit vorzugsweise eine höhere Längserstreckung als die erste oder zweite Signalschnittstelle oder als die erste und die zweite Signalschnittstelle. Zusätzlich zu den oben bereits genannten Merkmalen der zweiten Kopplungselemente sind die dritten und vierten Kopplungselemente auf dem Kopplungsbaustein miteinander elektrisch leitend verbunden, vorzugsweise in Streifenform, um den Abstand zwischen den ersten Signalschnittstellen der beiden Chips zu überbrücken. In einer Variante können die dritten und vierten Kopplungselemente auch jeweils so durch Streifen verbunden sein, dass sie jeweils ein gemeinsames Kopplungselement bilden. In beiden Fällen sind die Streifen vorzugsweise parallel zueinander angeordnet.

Bei dieser erfindungsgemäßen Chip-Anordnung können zunächst die beiden Chips relativ zueinander positioniert werden. Anschließend kann durch Positionierung des Kopplungsbausteins die Kopplung zwischen erstem und zweitem Chip bewirkt werden. Dabei wird die Positionierung in Abstands-Richtung durch die höhere Dichte zweiter Kopplungselemente im Vergleich mit der Dichte erster Kopplungselemente auf dem ersten und zweiten Chip ganz wesentlich erleichtert. Alternativ können auch die Chips auf dem Kopplungsbaustein positioniert werden. Der Kopplungsbaustein kann dabei insbesondere auch einen Teil des Trägers für die Chips bilden.

Die laterale Positionierung der zweiten Kopplungselemente (mit höherer Anzahldichte) in einer Richtung senkrecht zur Abstandsrichtung der ersten Kopplungselemente kann in beiden erfindungsgemäßen Chip-Anordnungen durch eine streifenförmige Ausbildung der ersten Kopplungselemente erleichtert werden. Die Streifenform der ersten Kopplungselemente ist jedoch nicht zwingend. Es können auch erste Kopplungselemente in anderer Form vorgesehen sein, beispielsweise quadratischer Form, ovaler oder Ellipsenform oder in Kreisform. Dabei können zur Erleichterung der Positionierung mehrere Reihen erster Kopplungselemente in einer matrixförmigen Anordnung vorgesehen sein. Ist diese Matrix beispielsweise längs einer Kante eines Chips angeordnet und verläuft eine "Reihe" der Matrix längs diese Kante, so genügt für die Kopplung ein Kopplungselement einer "Spalte". Auf diese Weise besteht auch in Richtung senkrecht zur Kante eine gewisse Toleranz bei der Positionierung.

Die erfindungsgemäße Chip-Anordnung kann mehr als zwei Chips umfassen. Dabei kann vorgesehen sein, dass eine Signalschnittstelle eines ersten Chips für eine kontaktlose Signalübertragung mit mehreren Chips ausgebildet ist. Diese Chips können jeweils eine Teilanzahl von Kopplungselementen der Signalschnittstelle des ersten Chips nutzen. Beispielsweise kann die Hälfte der Kopplungselemente der Signalschnittstelle des ersten Chips für eine kontaktlosen Signalaustausch mit einem zweiten Chip genutzt werden. Die andere Hälfte kann zum kontaktlosen Signalaustausch mit einem dritten Chip genutzt werden. In einer solchen Anordnung kann der erste Chip beispielsweise erste Kopplungselemente, also Kopplungselemente mit einer geringeren Dichte aufweisen. Der zweite und der dritte Chip weisen dann zweite Kopplungselemente, also Kopplungselemente mit einer hohen Dichte auf. Diese Anordnung entspricht einer Chip-Anordnung gemäß dem ersten Aspekt der Erfindung. Ein Chip kann auch mehrere solcher Signalschnittstellen aufweisen, beispielsweise eine in Sende- und eine in Empfangsrichtung, oder jeweils eine zu einem weiteren Chip. Solche Anordnungen sind zwar signaltechnisch schwerer zu handhaben und daher aufwendiger im Betrieb, bieten aber den Vorteil einer besonders hohen Packungsdichte.

In einer Chip-Anordnung gemäß dem zweiten Aspekt der Erfindung mit drei Chips weisen alle drei Chips erste oder zweite Kopplungselemente auf. Sie werden so zueinander angeordnet, dass sie mit Hilfe des Kopplungsbausteines, der nachfolgend auch als Brücke bezeichnet wird, gekoppelt werden können. Alternativ können zwei Kopplungsbausteine verwendet werden. Dabei können auf dem ersten Chip zwei Signalschnittstellen vorgesehen sein, deren eine mit dem zweiten Chip und deren andere mit dem dritten Chip gekoppelt wird. In einem alternativen Ausführungsbeispiel einer Chip-Anordnung mit drei Chips ist der erste Chip mit dem zweiten Chip und der zweite Chip mit dem dritten Chip gekoppelt. Diese Beispiele zeigen, dass auf der Basis der vorliegenden Erfindung allgemein eine Kopplung mehrerer Chips in unterschiedlichen Konfigurationen möglich ist.

Die erfindungsgemäße Chip-Anordnung beruht auf der Verwendung neuartiger Signalschnittstellen. Diese können auf einem Chip ausschließlich vorgesehen sein, alternativ aber auch zusätzlich zu vorbekannten Kopplungselementen wie beispielsweise herkömmlichen Bond-Pads.

Ein weiterer Vorteil der erfindungsgemäßen Lösung besteht in diesem Zusammenhang darin, dass die erfindungsgemäßen Signalschnittstellen insbesondere mit einer im Vergleich zu vorbekannten Lösungen sehr hohen Dichte an Kopplungselementen gefertigt werden können. So liegt das Rastermaß, also die Summe von Abstand und Breite der Kopplungselemente, in einem Ausführungsbeispiel bei der ersten Signalschnittstelle in der Größenordnung von 10 $\mu$m. Dieses Rastermaß kann in alternativen Ausführungsbeispielen nur 5, aber auch bis zu 25 $\mu$m betragen. Die Größenordnung von 10 $\mu$m, die für das Rastermaß der ersten Signalschnittstelle problemlos realisierbar ist, ist deutlich geringer als das Rastermaß herkömmlicher Bond-Pads und ermöglicht eine kontaktlose Kopplung von Chips über einen breiten Datenbus mit sehr hohem Datendurchsatz. Für die Chip-Fertigung stellen derartige Signalschnittstellen kein Problem dar. Mit der erfindungsgemäßen Chip-Anordnung gemäß dem ersten oder dem zweiten Aspekt werden auch die Kontaktierungsprobleme bei der Herstellung einer Chip-Anordnung gelöst.

Die ersten und zweiten Kopplungselemente sind in einem Ausführungsbeispiel der Erfindung ausgebildet, die Kontakte zur Signalübertragung mit Hilfe kapazitiver Kopplung zwischen jeweils einem ersten und einem oder mehreren zweiten Kopplungselementen zu bewirken. Die Impedanz der kapazitiven Verbindung muss dabei klein genug sein relativ zur minimalen Impedanz zwischen den Leitbahnen und zu den minimalen Impedanzen gegen Masse, so dass die Dämpfung über das gesamte Verbindungssystem aus der Sicht des Rauschabstandes und des Übersprechens noch tolerierbar ist. Diese Forderung nach hinreichend hoher Durchgangskapazität ist erfüllbar, wenn die ersten und zweiten Kopplungselemente genügend dicht planar aufeinander aufliegen.

Eine Verbesserung der kapazitiven Kopplung wird erreicht, wenn ein Füllstoff mit hoher Dielektrizitätskonstante zwischen den ersten und zweiten Kopplungselementen angeordnet ist. Der Füllstoff kann eine kapazitive Überbrückung von Lücken und Unregelmäßigkeiten bilden.

Die ersten und zweiten Kopplungselemente können dann durch eine dünne isolierende Schicht geschützt werden. Diese kann eine dünne Passivierungsschicht sein, eine spontane oder induzierte Oxidschicht oder eine zusätzlich aufgetragene Schicht. Dies hat bei hohen Stückzahlen keinen oder wenig Einfluss auf die Fertigungskosten, da die Passivierungsschicht bereits alles außer den Kopplungselementen maskiert, sodass die hierfür nötige Maske sehr grob sein kann. Sie muss lediglich Bereiche normaler Kopplungselemente von denen der erfindungsgemäßen ersten bzw. zweiten Kopplungselemente trennen. Der durch die Isolation erzeugte Schutz erlaubt es, wesentlich kleinere oder gar keine ESD-Schutzstrukturen zu verwenden, so dass die parasitäre kapazitive Belastung sinkt, was zu höherer Bandbreite und kleiner Verlustleistung führt.

Alternativ kann die kontaktlose Signalübertragung auch mit Hilfe induktiver, alternativ kapazitiver und induktiver Kopplung erfolgen. Die kontaktlose Signalübertragung kann auch den Charakter einer Übertragung über eine Funkstrecke annehmen. Hierbei wirken die sender- und empfängerseitigen Kopplungselemente wie Antennen. Diese Art der kontaktlosen Signalübertragung wird hier als elektromagnetisch bezeichnet.

Erfindungsgemäß ist die erste Signalschnittstelle längs einer Kante des ersten Chips und die zweite Signalschnittstelle längs einer Kante des zweiten Chips vorgesehen. Diese Kanten des ersten und zweiten Chips sind einander zugewandt angeordnet. Die Kanten können dabei nebeneinander oder übereinander angeordnet sein. Die Anordnung längs einer Kante ist Platz sparend und lässt große Chipoberflächenanteile frei verfügbar für andere Funktionen, wie beispielsweise Kühlung oder Kontaktierung mit herkömmlichen Techniken.

In einem Ausführungsbeispiel gemäß dem ersten Aspekt der Erfindung liegt der zweite Chip dabei zumindest teilweise auf dem ersten Chip auf. Auf diese Weise werden die Chips direkt miteinander kontaktlos gekoppelt. Ein separater Kopplungsbaustein ist nicht erforderlich. Der Vorteil dieser Anordnung liegt darin, dass die zweiten Kopplungselemente in ihrer Längserstreckung kürzer ausgebildet werden können als bei der Anordnung mit einem Kopplungsbaustein. Bei einer solchen Anordnung kann der erste Chip (z. B. der Prozessor) als flip-chip ausgebildet sein.

Grundsätzlich ist eine solche Anordnung auch bei einer Chip-Anordnung gemäß dem zweiten Aspekt der Erfindung möglich, erfordert jedoch eine spezielle, aufwändigere Ausbildung des Kopplungsbausteins. Denn der Kopplungsbaustein liegt hier zwischen den Chips und muss mit dem einem Chip auf seiner Oberseite und mit dem anderen Chip auf seiner Unterseite koppeln. Die zweiten Kopplungselemente müssen also auf beiden Seiten des Kopplungsbausteins vorgesehen sein und ein Kopplungselement der Oberseite mit dem entsprechenden Kopplungselement der Unterseite verbunden sein. Das kann bei einem plättchenförmigen Kopplungsbaustein beispielsweise erreicht werden, indem die Kopplungselemente sich auch über eine Seitenkante des Kopplungsbausteins hinweg von der Unterseite zur Oberseite fortsetzen.

In einem weiteren Ausführungsbeispiel gemäß dem ersten Aspekt der Erfindung ist eine Anordnung von beiden Chips auf einer Trägerfläche nebeneinander vorgesehen. Die Kopplungselemente sind so ausgebildet, dass sie jeweils über eine Seitenfläche des Chips miteinander koppeln können. Dies geschieht beispielsweise, indem Spulen auf den Chips so angeordnet sind, dass ihr Magnetfeld durch eine Seitenfläche des jeweiligen Chips verläuft. Solche Spulen mit einer horizontalen Achse des Magnetfeldes können im Metallsystem von Chips erzeugt werden, indem Durchkontaktierungen zwischen den Metall-Ebenen als senkrechte Leiterzüge verwendet werden. Diese Anordnung hat den Vorteil, dass weitere auf einem Chip oder auf beiden Chips vorgesehene konventionelle Kopplungselemente wie Bond-pads mit herkömmlicher Technik einfach kontaktiert werden können.

In einer bevorzugten Ausführungsform der Chip-Anordnung gemäß dem zweiten Aspekt der Erfindung ist ebenfalls eine Anordnung von beiden Chips auf einer Trägerfläche nebeneinander vorgesehen. Beispielsweise können beide Chips ihre Kopplungselemente auf der von der Trägerfläche abgewandten Seite haben. Die Kopplungselemente beider Chips werden dann beispielsweise nach oben weisend angeordnet sein. Wichtig ist, dass die Chips senkrecht zur Trägerfläche (in z-Richtung) gut abgestimmt sind, damit der Kopplungsbaustein, die Brücke, in etwa plan aufliegen kann.

Bei einer bevorzugten Ausführungsform der Erfindung lässt sich die Anzahl der Kopplungselemente der zweiten Signalschnittstelle, also der Signalschnittstelle mit der höheren Anzahldichte, die in dieser Ausführungsform außerdem eine höhere Längserstreckung hat, zur Anzahl N1 der Kopplungselemente der Signalschnittstelle mit der geringeren Anzahldichte als N2=g*N1+X darstellen. Dabei ist g eine Zahl > 1 und X die Anzahl der Kopplungselemente, die in dem überschießenden Längsabschnitt der Signalschnittstelle liegen, welche eine höhere Längserstreckung hat. Hat beispielsweise die erste Signalschnittstelle N1 = 100 Kopplungselemente im 10 μm-Raster, die zweite Signalschnittstelle auf dieser Breite 200 Kopplungselemente im 5 μm-Raster und darüber hinaus an den längsseitigen Rändern zusätzlich je 10, also insgesamt 20, Kopplungselemente an beiden Rändern, um grobe Versetzungen aufzufangen, so beträgt in diesem Beispiel g = 2 und X = 20.

In einer weiteren bevorzugten Ausführungsform weist die Signalschnittstelle desjenigen Chips, welcher im Signalfluss zwischen dem ersten und dem zweiten Chip einen Empfänger bildet (nachfolgend Empfänger-Chip), Kopplungselemente mit der höheren Anzahldichte auf. Auf diese Weise kann die Signalübertragung weniger aufwendig betrieben werden. Da ein angeschlossener Sender leichter zu detektieren ist als ein angeschlossener Empfänger, ist es sinnvoll, dass der Chip mit der Überzahl zweiter Kopplungselemente auf der jeweiligen Empfängerseite vorgesehen ist.

In einer bevorzugten Ausführungsform ist auf dem Chip, der eine Überzahl zweiter Kopplungselemente aufweist, eine Empfangsauswahlschaltung vorgesehen. Die Empfangs-Auswahlschaltung weist für jedes Kopplungselement einen mit ihm verbundenen Eingang auf und ist ausgebildet, aus an ihren Eingängen anliegenden Eingangssignalen anhand vordefinierter Signalkriterien mit aktiven Kopplungselementen verbundene Eingänge zu ermitteln und nur diejenigen Eingangssignale auszugeben, die von den aktiven Kopplungselementen empfangen werden.

Anstelle der Erkennung einer Signalaktivität kann das Auswahlkriterium für ein aktives Kopplungselement auch ein Signal mit bestimmten Erkennungszeichen sein, beispielsweise ein Pegelwechsel mit einer bestimmten Phasenlage relativ zu allen anderen Ausgangssignalen. Auf diese Weise kann der Rand des Signalvektors eindeutig gekennzeichnet werden.

Der Chip ohne Überzahl erster Kopplungselemente weist in einer bevorzugten Ausführungsform daher je ein Randkopplungselement an den Enden seiner ersten Signalschnittstelle auf und ist ausgebildet, an die Randkopplungselemente ein vordefiniertes Randsignal anzulegen.

In einer bevorzugten Ausführungsform ist auf dem Empfänger-Chip eine der Signalschnittstelle nachgeschaltete Filterschaltung vorgesehen, die ausgebildet ist, von senderseitigen Kopplungselementen ausgesandte Signale anhand der von den empfängerseitigen Kopplungselementen empfangenen Signale zu rekonstruieren.

Die Filterschaltung kann vorwiegend nach geometrischen oder vorwiegend nach einem signalvereinbarenden Prinzip oder nach einer Mischform beider arbeiten. Bei einer vorwiegend nach geometrischer Selektion der empfängerseitigen Kopplungselemente ausgerichteten Filterschaltung weist diese eine Anzahl von Wichtungselementen auf, die jeweils ausgebildet sind, von mehreren empfängerseitigen Kopplungselementen empfangene Signale mit veränderbaren Wichtungsfaktoren zu multiplizieren und die so gewichteten Signale zu addieren.

Dabei sind in einer bevorzugten Ausführungsform die empfängerseitigen Kopplungselemente mit mehreren Wichtungselementen verbunden. Die Gesamtzahl der Wichtungselemente ist vorzugsweise gleich der Anzahl der senderseitig vorgesehenen Kopplungselemente. Die Wichtungselemente dienen also der Rekonstruktion der Trennung der durch die senderseitigen Kopplungselemente gebildeten Übertragungskanäle.

Vorzugsweise ist eine mit den Kopplungselementen und der Filterschaltung verbundene Steuereinheit vorgesehen, die ausgebildet ist, die Wichtungsfaktoren zu bestimmen. Die Steuereinheit kann beispielsweise ausgebildet sein, für jedes Wichtungselement die an den mit dem Filter verbundenen, empfängerseitigen Kopplungselementen empfangenen Signale jeweils mit einem vordefinierten Signalmuster zu vergleichen und den Kopplungselementen jeweils einen vom Vergleichsergebnis abhängigen Wichtungsfaktor zuzuordnen.

In einer einfachen Ausführungsform ist die Steuereinheit ausgebildet, pro Wichtungselement maximal einem bis drei Kopplungselementen einen von null verschiedenen Wichtungsfaktor zuzuordnen, derart, dass die Summe aller Wichtungsfaktoren pro Wichtungselement 1 beträgt.

In einer vorwiegend unter dem Aspekt der Signalverarbeitung gestalteten Ausführungsform weist die Filterschaltung zusätzlich oder alternativ eine Anzahl Filterbänke auf, wobei jede Filterbank eingangsseitig mit einer Anzahl Kopplungselementen verbunden ist. Vorzugsweise weist jede Filterbank eine Anzahl Filter auf, deren jedes eingangsseitig mit einem Kopplungselement verbunden ist. Dabei ist jeder Filter beispielsweise ausgebildet, ein Ausgangssignal abzugeben, das von einer gewichteten Summe des aktuellen und einer Anzahl zeitlich vorangegangener Signale an seinem Eingang abhängt. Vorzugsweise ist also das Ausgangssignal eines Filters dieser Art entsprechend folgender Formel zu bestimmen:

$$A(z) = \sum_{j=1}^{r} S(j) \cdot w(j,z)$$
,

wobei S(j) ein an einem Filtereingang in einem Zeitschritt j anliegendes Signal ist, r die Gesamtzahl der berücksichtigten Zeitschritte, w ein vom jeweiligen Zeitschritt j abhängiger Wichtungsfaktor und z ein das Filter bezeichnender Index. Ein solches Filter weist beispielsweise eine Signalverzögerungskette (delay line) mit r-Verzögerungselementen, r-Multiplizierern und einem Addierer auf. Jedem bis auf das letzte Verzögerungselement ist parallel ein Multiplizierer und ein Verzögerungselement nachgeschaltet. Dem letzten Verzögerungsglied ist selbstverständlich ein Multiplizierer nachgeschaltet. Die Ausgänge der Multiplizierer sind mit parallelen Eingängen des Summierers verbunden.

Bevorzugt weist jede Filterbank eine den Filtern nachgeschaltete Wichtungseinheit auf, die ausgebildet ist, von den Filtern der jeweiligen Filterbank empfangene Signale mit veränderbaren Wichtungsfaktoren zu multiplizieren und die so gewichteten Signale zu addieren. Die Bestimmung der Wichtungsfaktoren erfolgt vorzugsweise wiederum mit einer Steuereinheit. Die Steuereinheit ist vorzugsweise ausgebildet, in einer Trainingsphase die an den empfängerseitigen Kopplungselementen anliegenden Signale einer Korrelation mit einem oder mehreren bekannten Signalmustern zu unterziehen und anhand des Korrelationsergebnisses die Wichtungsfaktoren der Filter und der Wichtungsschaltung zu bestimmen. Die Wichtungsfaktoren der Filter sind andere als die der Wichtungsschaltung.

Gemäß einem dritten Aspekt der Erfindung wird ein Verfahren zur Herstellung einer Chip-Anordnung nach Anspruch 2 bereitgestellt, mit den Schritten:

a) Positionierung des ersten Chip auf einem Träger
b) Positionierung des zweiten Chip relativ zum ersten Chip auf dem Träger
c) Positionieren eines Kopplungsbausteins gemäß Anspruch 17 zur Herstellung einer kontaktlosen Kopplung für die Signalübertragung zwischen dem ersten und zweiten Chip,

Weitere Ausführungsbeispiele der Erfindung werden nachfolgend anhand von Figuren beschrieben. Es zeigen:

Figur 1    ein erstes Ausführungsbeispiel einer Chip-Anordnung;

Figur 2    ein zweites Ausführungsbeispiel einer Chip-Anordnung;

Figur 3    das Ausführungsbeispiel der Figur 2 in höherer Vergrößerung;

Figur 4    das Ausführungsbeispiel der Figur 2 in weiter erhöhter Vergrößerung;

Figur 5    eine Modifikation dieses Ausführungsbeispiels;

Figur 6    eine schematische Querschnittsansicht eines dritten Ausführungs- beispiels einer erfindungsgemäßen Chip-Anordnung;

Figur 7    ein viertes Ausführungsbeispiel einer erfindungsgemäßen Chip- Anordnung in einer schematischen Draufsicht;

Figur 8    das Ausführungsbeispiel der Figur 7 in einer schematischen Quer- schnittsansicht;

Figur 9    eine schematische Darstellung relevanter Maße von Kopplungsele- menten;

Figur 10    eine schematische Draufsicht eines fünften Ausführungsbeispiels einer Chip-Anordnung, die zusätzliche Kopplungselemente auf Seiten des Empfängers aufweist;

Figur 11    ein sechstes Ausführungsbeispiel in einer schematischen Draufsicht, bei dem senderseitig Kopplungselemente zur Erzeugung von Rand- signalen vorgesehen sind;

Figur 12 eine schematische Querschnittsansicht eines siebten Ausführungs- beispiels einer Chip-Anordnung mit einem Kopplungsbaustein;

Figur 13 eine schematische Querschnittsansicht eines achten Ausführungs- beispiels in einer Flip-Chip-Anordnung;

Figur 14 ein neuntes Ausführungsbeispiel in einer weiteren Flip-Chip- Anordnung;

Figur 15 ein Anwendungsbeispiel der erfindungsgemäßen Chip-Anordnung;

Figur 16 ein vereinfachtes Blockschaltbild einer empfängerseitigen Schaltung zur Signalaufbereitung.

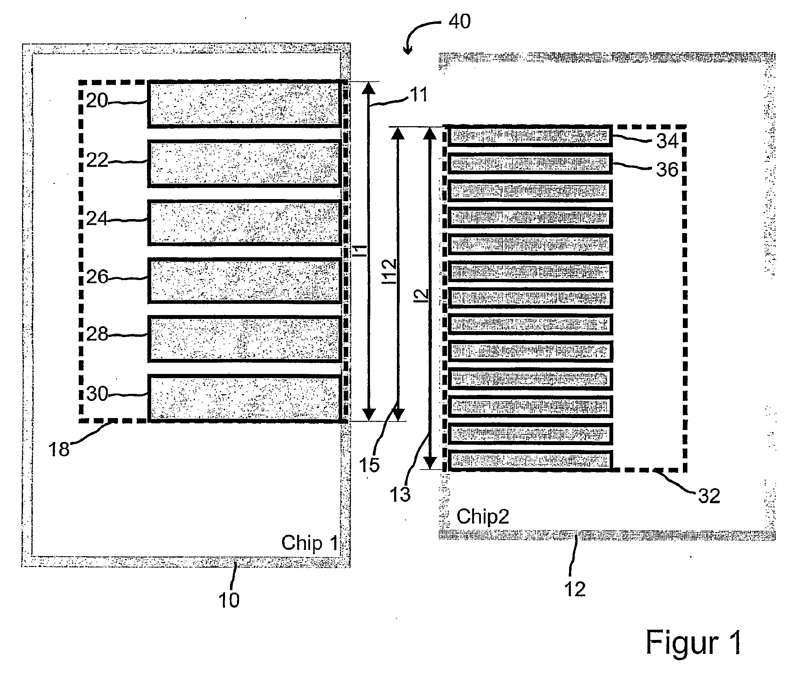

Figur 1 zeigt eine abstrakte schematische Darstellung eines ersten Ausführungsbeispiels einer erfindungsgemäßen Chip-Anordnung. Zwei Chips 10 und 12 sind in einer schematischen Draufsicht dargestellt. Der erste Chip 10 hat eine erste Signalschnittstelle 18 mit einer Vielzahl von Kopplungselementen und einer ersten Anzahldichte. Zur Vereinfachung der Darstellung sind hier nur wenige Kopplungselemente 20 bis 30 dargestellt. Die Anzahldichte ist die Anzahl der Kopplungselemente pro Längserstreckung der Signalschnittstelle. Diese Längserstreckung 11 der Signalschnittstelle 18 hat in Figur 1 die Länge l1. Der Signalschnittstelle 18 des ersten Chips 10 gegenüberliegend befindet sich auf dem zweiten Chip eine zweite Signalschnittstelle 32 mit Kopplungselementen, die in größerer Anzahldichte angeordnet sind als die Kopplungselemente 20 bis 30 der Signalschnittstelle 18. Die Größenverhältnisse sind in der schematischen Darstellung in Figur 1 nicht maßstabsgetreu. Im Normalfall werden die Signalschnittstellen 18 bzw. 32 nur einen kleinen Teil der jeweiligen Chip-Oberfläche einnehmen, und die Chips können weitere Elemente an der Oberfläche aufweisen, z.B. herkömmliche Bondpads. Die Kopplungselemente sind in Figur 1 symbolisch als Rechtecke mit grauer Füllung dargestellt. In der realen Ausführung kann die Form der Kopplungselemente anders sein. Sie können auch dreidimensionale Strukturen sein, beispielsweise Spulen. Die Längserstreckung 13 der Signalschnittstelle 32 hat in Figur 1 die Länge l2. Der Übersichtlichkeit halber sind nur zwei Kopplungselemente 34 und 36 mit Bezugszeichen versehen. Die Kopplungselemente beider Signalschnittstellen sind längs der Kante der Chips, die dem jeweils anderen Chip zugewandt ist, angeordnet. Die Überlappung 15 beider Längserstreckungen 11 und 13 hat in Figur 1 die Länge l12. Projiziert man die erste Längserstreckung 11 auf die Linie der zweiten Längserstreckung 13, so bildet der gemeinsame Bereich, den die dadurch entstehende projizierte Strecke mit der zweiten Längserstreckung 13 hat, die Strecke der Überlappung 15. Der erste Chip 10 und der zweite Chip 12 sind relativ zueinander so angeordnet, dass Kopplungselemente der ersten Signalschnittstelle 18 und Kopplungselemente der zweiten Signalschnittstelle 32 miteinander kontaktlos Signale übertragen können. Im dargestellten Fall können die Kopplungselemente beispielsweise horizontale Spulen sein, also Induktivitäten, deren Längsachsen des Magnetfeldes in horizontaler Ebene parallel zur Oberfläche des Chips angeordnet sind. Diese Längsachsen sind in Figur 1 jeweils parallel zur längeren Seite jedes Kopplungselements, und damit senkrecht zu der Kante des Chips, die dem anderen Chip zugewandt ist. Trotz des in Figur 1 sichtbaren Versatzes der Signalschnittstellen 18 und 32 zueinander gibt es im Bereich der Überlappung 15 Kopplungselemente der Signalschnittstelle 18 des ersten Chips 10, die mit Kopplungselementen der Signalschnittstelle 32 des zweiten Chips 12 koppeln. Im Beispiel der Ausführung der Kopplungselemente als horizontale Spulen ist das eine Kopplung der Magnetfelder von Induktivitäten der Signalschnittstelle 18, die über den Zwischenraum 40 hinweg mit Induktivitäten der Signalschnittstelle 32 auf dem anderen Chip wechselwirken. Einem Kopplungselement der Signalschnittstelle 18 des ersten Chips 10 kann dabei ein Kopplungselement oder auch mehrere Kopplungselemente der Signalschnittstelle 32 des zweiten Chips 12 zugeordnet sein. Beispielsweise können alle Kopplungselemente der Signalschnittstelle 18 als Sender angesteuert sein, und alle Kopplungselemente der Signalschnittstelle 32 als Empfänger. Durch weitere Maßnahmen, wie Auswahlschaltungen und Filter, z.B. den Empfängern nachgeschaltet, werden die übertragenen Signale zugeordnet und rekonstruiert. Da damit die Zuordnung der einzelnen Kopplungselemente der Signalschnittstelle 18 zu den Kopplungselementen der Signalschnittstelle 32 flexibel an die reale Position angepasst werden kann, gibt es eine hohe Toleranz gegenüber einem Versatz der Chips in Richtung der Längserstreckungen 11 und 13. Dies vereinfacht die Positionierung der Chips zueinander.

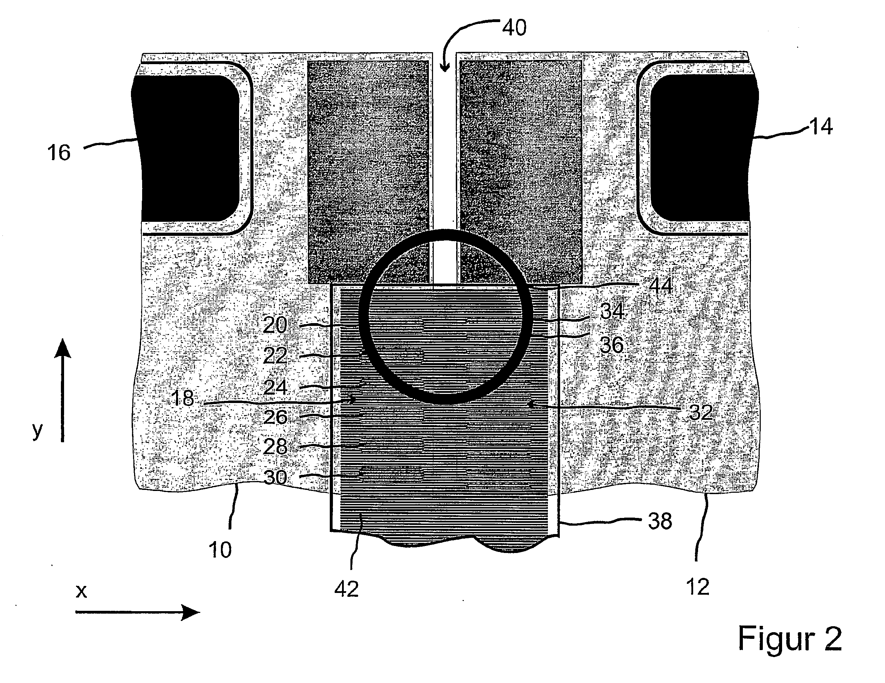

Figur 2 zeigt zweites Ausführungsbeispiel einer erfindungsgemäßen Chip-Anordnung. Hier werden für entsprechende Elemente die gleichen Bezugszeichen gewählt wie in Figur 1. Auch hier sind zwei Chips 10 und 12 in einer schematischen Draufsicht dargestellt. Die Chips 10 und 12 weisen herkömmliche Bond-Pads 14 und 16 auf. Weiterhin hat der erste Chip 10 eine erste Signalschnittstelle 18 mit einer Vielzahl von Kopplungselementen, von denen hier nur die Kopplungselemente 20 bis 30 dargestellt sind. In der Figurenschreibung werden durchgängig die Richtungen x und y, die in Figur 2 anhand von Pfeilen dargestellt sind, für die lateralen Richtungen in der Chip-Oberfläche verwendet. Eine hier noch nicht dargestellte z-Richtung weist in Tiefenrichtung der Chips senkrecht zur Chip-Oberfläche und damit senkrecht zur Papierebene. Der Signalschnittstelle 18 des ersten Chips 10 gegenüberliegend befindet sich auf dem zweiten Chip eine zweite Signalschnittstelle 32 mit Kopplungselementen, die in der y-Richtung in größerer Anzahldichte angeordnet sind als die Kopplungselemente 20 bis 30 der Signalschnittstelle 18. Der Übersichtlichkeit halber sind nur zwei Kopplungselemente 34 und 36 mit Bezugszeichen versehen. Die Kopplungselemente beider Signalschnittstellen sind längs der Kante der Chips, die in Figur 2 parallel zur y-Richtung verläuft, angeordnet. Die Kopplungselemente haben die Form von Streifen, deren Längsrichtung parallel zur x-Richtung weist. Die Kopplungselemente der ersten Signalschnittstelle 18 weisen deutlich sichtbar eine größere Breite in y-Richtung auf als die der zweiten Signalschnittstelle 32 des Chips 12. Die Signalschnittstellen 18 und 32 der beiden Chips 10 und 12 sind über einen Kopplungsbaustein 38 signaltechnisch verbunden. Der Kopplungsbaustein liegt auf beiden Chips im Bereich ihrer einander zugewandten Kanten auf und überdeckt die Signalschnittstellen 18 und 32. Der Kopplungsbaustein 38 weist eine große Anzahl von dritten und vierten Kopplungselementen auf, die in diesem Fall jeweils zu einheitlichen Kopplungselementen in Streifenform verbunden sind, welche sich in x-Richtung von jenseits der Kopplungselemente der Signalschnittstelle 18 über einen zwischen den Chips befindlichen Zwischenraum 40 hinweg erstrecken bis jenseits der Kopplungselemente der Signalschnittstelle 32 des Chips 12. In y-Richtung haben die Kopplungsstreifen des Kopplungsbausteins 38 eine im Vergleich mit den Kopplungselementen der beiden Chips deutlich geringere Breite und höhere Anzahldichte. Die Kopplungsstreifen des Kopplungsbausteins 38 sind in Figur 2 grau dargestellt. Exemplarisch ist ein Kopplungsstreifen 42 gekennzeichnet. In Figur 2 ist ein Ring 44 eingezeichnet, der allein zur Verdeutlichung des Maßstabes der nachfolgenden Figuren dient.

Geht man von einer für die Signalschnittstellen 18 und 32 maximal nutzbaren Kantenlänge von ca. 10 bis 25 mm sowie einer Anzahl von etwa 1.000 bis 2.000 für den maximalen Durchsatz nötigen Kopplungselemente aus, so ergibt sich ein Rastermaß (pitch) in der Größenordnung von 5 bis 25 $\mu$m pro Kopplungselement.

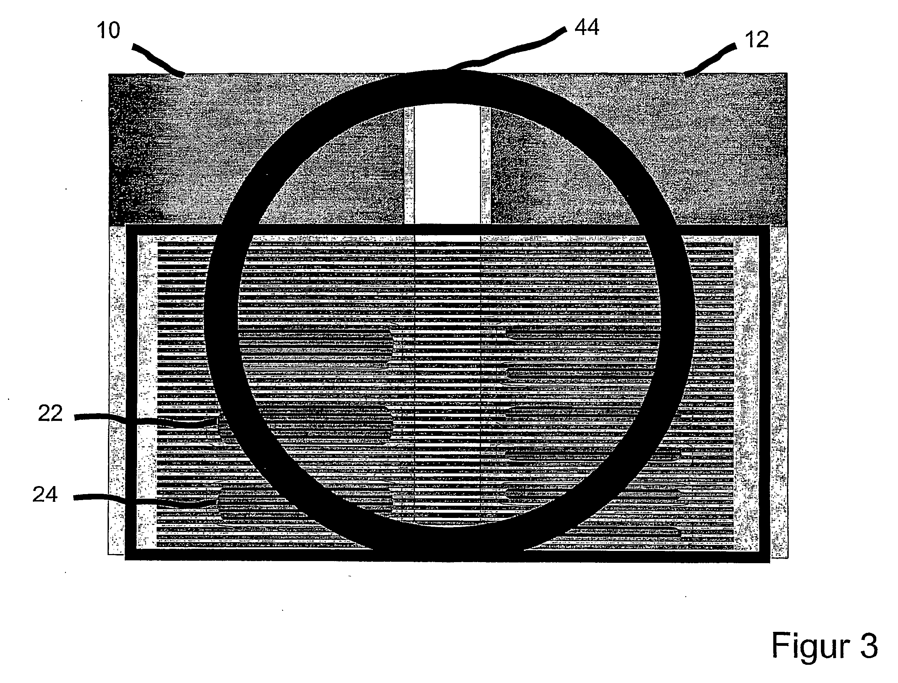

Figur 3 zeigt das Ausführungsbeispiel der Figur 2 in einem vergrößerten Ausschnitt. Hier wie in den Figuren 2, 4 und 5 ist der Kopplungsbaustein lediglich zum Zwecke der Erläuterung transparent dargestellt. Beispielsweise können die Kopplungselemente 20 bis 30 der Signalschnittstelle 18 ein Rastermaß von 10 $\mu$m und die Kopplungselemente der Signalschnittstelle 32 ein Rastermaß von 5 $\mu$m aufweisen. Sind z.B. 1.000 Kopplungselemente auf dem Chip 10 und 2.500 Kopplungselemente auf dem Chip 12 vorgesehen, so beträgt die Längserstreckung der Signalschnittstellen auf den Chips 10 mm bzw. 12,5 mm. Sollen alle 1.000 Kopplungselemente auf dem Chip 10 genutzt werden, so muss die Überlappung beider Längserstreckungen die gesamte Längserstreckung des Chips 10 umfassen. Diese Überlappung ist dann ebenfalls 10 mm lang. Werden die Chips in y-Richtung so zueinander positioniert, dass beim Sollwert die Signalschnittstellen genau mittig zueinander liegen, so kann ein Versatz der Signalschnittstellen zueinander um diesen Sollwert in y-Richtung von 0,5*(12,5-10) mm toleriert werden, also 1,25 mm, in Figur 3 nach oben oder unten. Welches Kopplungselement des Chips 10 welches Kopplungselement des Chips 12 erreicht, muss nach der Positionierung festgestellt werden, z. B. automatisch beim Einschalten des Systems, indem Chip 10 eine einfach erkennbare Sequenz der Reihe nach auf alle seine Kopplungselemente anlegt, und Chip 12 herausfindet, auf welchen Kopplungselementen jeweils der Empfang für das jeweilige Kopplungselement des Chips 10 am besten ist. In diesem Fall werden nur diese 1.000 der 2.500 Kopplungselemente des zweiten Chips dann im Betrieb verwendet. Ist der Versatz noch größer, und die Kopplungselemente Die anderen werden dann deaktiviert, es sei denn, sie werden zusätzlich zur selektiven Signalrückgewinnung verwendet (vgl. unten).

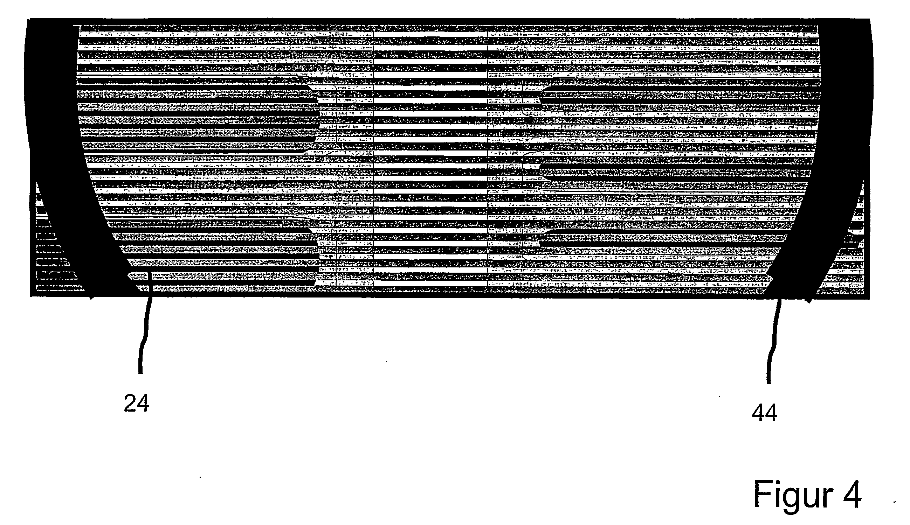

Figur 4 zeigt das Ausführungsbeispiel der Figuren 2 und 3 in weiterer vergrößerter Darstellung. Es ist nicht notwendig, dass mehr Empfänger und weniger Sender verwendet werden. Das Verhältnis kann auch umgekehrt sein.

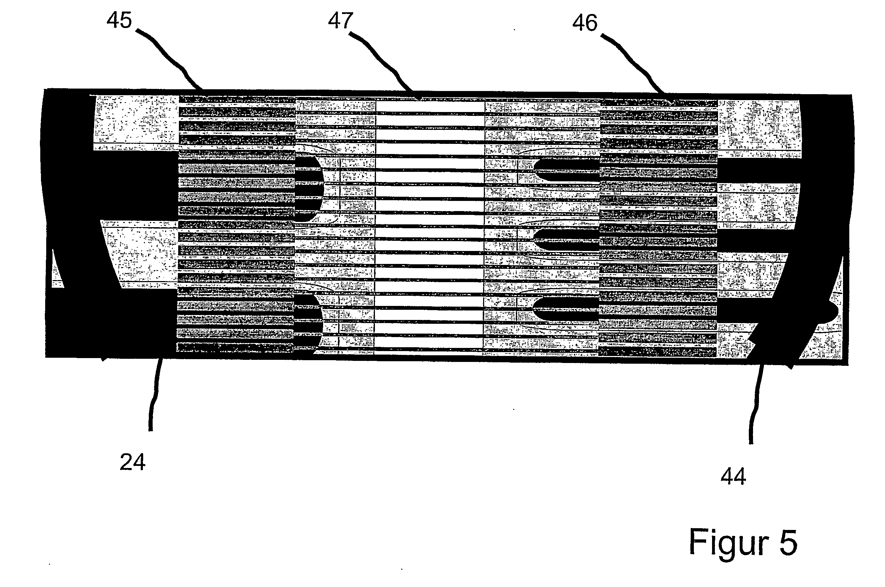

Figur 5 zeigt eine Modifikation dieses Ausführungsbeispiels. Hierbei sind die Verbindungen 47 zwischen den dritten Kopplungselementen 45 und vierten Kopplungselementen 46 des Kopplungsbausteins schmaler ausgeführt als die Breite der Kopplungselemente 45 und 46. Dies kann vorteilhaft sein, um unerwünschte Kapazitäten im Signalpfad zu verringern. Zum einen wird damit das Verhältnis von erwünschter Durchgangskapazität zu unerwünschter Lastkapazität erhöht, zum anderen wird das Übersprechen zwischen den Verbindungen 47 verringert. Eine weitere Maßnahme zur Verringerung des Übersprechens, die in Figur 5 nicht dargestellt ist, kann das Anbringen von metallischen Abschirmungen zwischen den Verbindungen 47 sein, die diese Verbindungen 47 auch jeweils an allen Längsseiten umschließen können. Zusätzlich können auch die Kopplungselemente 45 und 46 davon umschlossen werden, bis auf die zur Kopplung benötigte Fläche.

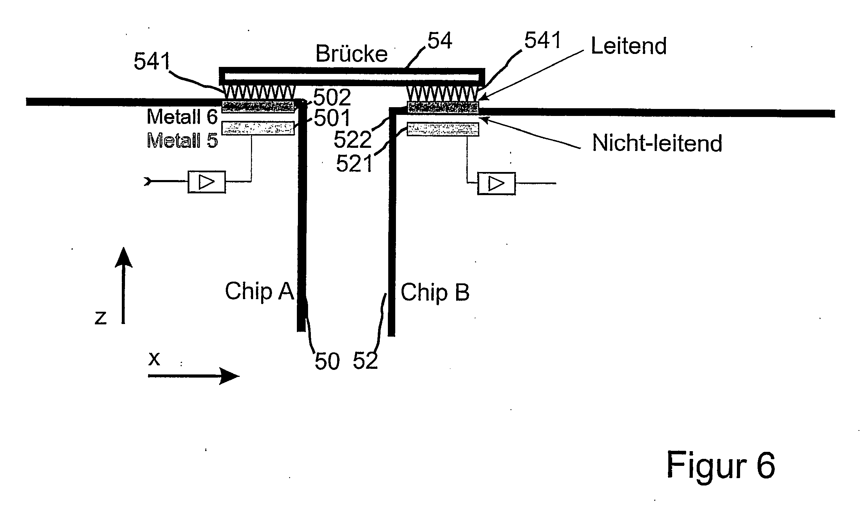

Figur 6 zeigt ein drittes Ausführungsbeispiel einer Chip-Anordnung mit zwei Chips 50 und 52, die in Figur 6 auch als Chip A und Chip B gekennzeichnet sind. Die Chips sind über einen Kopplungsbaustein 54 signaltechnisch miteinander verbunden. In diesem Fall findet die kontaktlose Kopplung bereits jeweils innerhalb der Chips statt, und zwar zwischen den metallischen Leitern 501 und 502 für Chip 50 bzw. 521 und 522 für Chip 52. Damit kann die äußere Verbindung zwischen den Chips auch eine elektrisch leitende Verbindung sein, ohne daß die innere Struktur der Chips 50 und 52 einen ESD-Schutz wie bei herkömmlicher Kontaktierung benötigt. Der Kopplungsbaustein 54 ist mit Kontaktflächen 541 ausgestattet, welche gezahnt oder gestuft sind. Auf diese Weise können Oberflächenrauhigkeiten und Staubpartikel auf den Kontaktflächen der Chips besser toleriert werden.

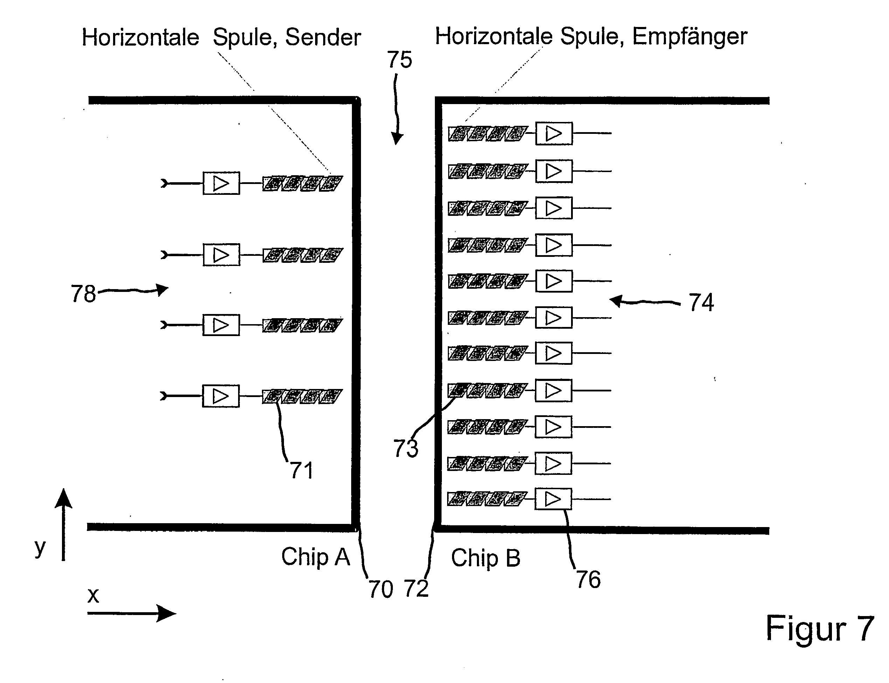

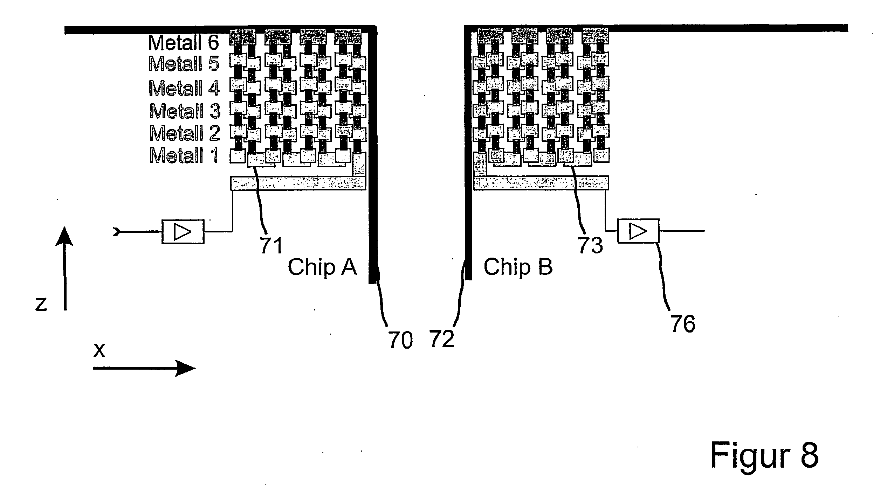

Figur 7 zeigt in einer schematischen Draufsicht ein viertes Ausführungsbeispiel einer erfindungsgemäßen Chip-Anordnung. Zwei Chips 70 und 72 sind einander gegenüberliegend angeordnet. Die dargestellten Chips eignen sich auch für eine Anordnung ohne Kopplungsbaustein. Bei den Kopplungselementen der Signalschnittstellen handelt es sich bei beiden Chips um horizontale Spulen 71 und 73. Diese können mittels ihrer horizontalen magnetischen Felder durch die einander zugewandten Seitenflächen der Chips in horizontaler Richtung koppeln. Daher können die Chips einfach auf einem Träger nebeneinander angeordnet werden, wenn sie eine gleiche Höhe haben. Da eine solche magnetische Kopplung eine größere Reichweite haben kann als eine kapazitive, kann damit auch ein Zwischenraum 75 zwischen den Chips leichter überbrückt werden. Die Struktur der Spulen ist anhand der Querschnittsdarstellung der Figur 8 näher zu erkennen. Den Spulen nachgeschaltet sind Signalverstärker, von denen beispielhaft der Signalverstärker 76 dargestellt ist. Der Querschnittsdarstellung der Figur 8 kann entnommen werden, dass sich die Spulen über mehrere Metallebenen in den Chips erstrecken. Durch diese Höhe der Spulen entsteht eine größere Induktivität sowie eine Toleranz gegenüber vertikalen Positionsungenauigkeiten.

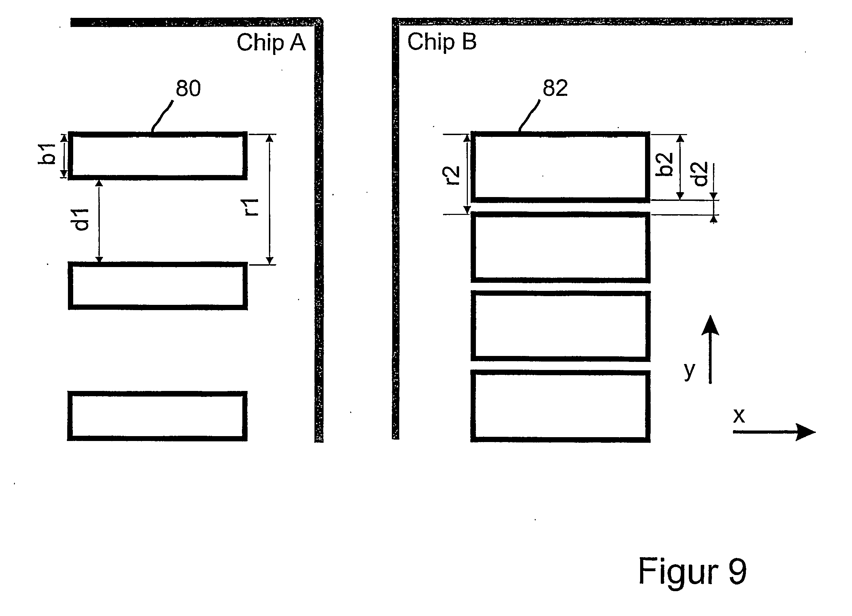

Figur 9 zeigt anhand eines Beispiels erste Kopplungselemente 80 und zweite Kopplungselemente 82 im Vergleich. Die zweiten Kopplungselemente 82 werden beispielsweise in einer Signalschnittstelle eines Chips oder auf einem Kopplungsbaustein verwendet. Sie entsprechen in ihrer Funktion den Kopplungselementen 34 und 36 der Figuren 1 und 2, während die ersten Kopplungselemente 80 den Kopplungselementen 20 bis 30 der Figuren 1 und 2 entsprechen. Die Skizze der Figur 9 dient lediglich dazu, die Verhältnisse von Breite und Abstand der ersten und zweiten Kopplungselemente anhand eines Beispieles im Vergleich darzustellen. Die ersten Kopplungselemente 80 weisen eine Breite b1 auf und einen wechselseitigen Abstand d1. Aus der Summe von b1 und d1 ergibt sich ein Rastermaß r1. Die zweiten Kopplungselemente 82 weisen eine Breite b2 auf. Diese ist kleiner als der Abstand d1. Es versteht sich, dass die Breite b2 auch kleiner sein kann als die Breite b1. Zur Vermeidung eines Übersprechens zwischen den ersten Kopplungselementen 80 ist es wichtig, dass b2 kleiner als d1 ist. Auf diese Weise wird ein Versatz in y-Richtung, die in Figur 9 anhand eines in Abstandsrichtung weisenden Pfeils dargestellt ist, vereinfacht. Eine streifenförmige Ausbildung in x-Richtung, die senkrecht zur y-Richtung in der Papierebene verweist, erleichtert die Positionierung auch in der x-Richtung.

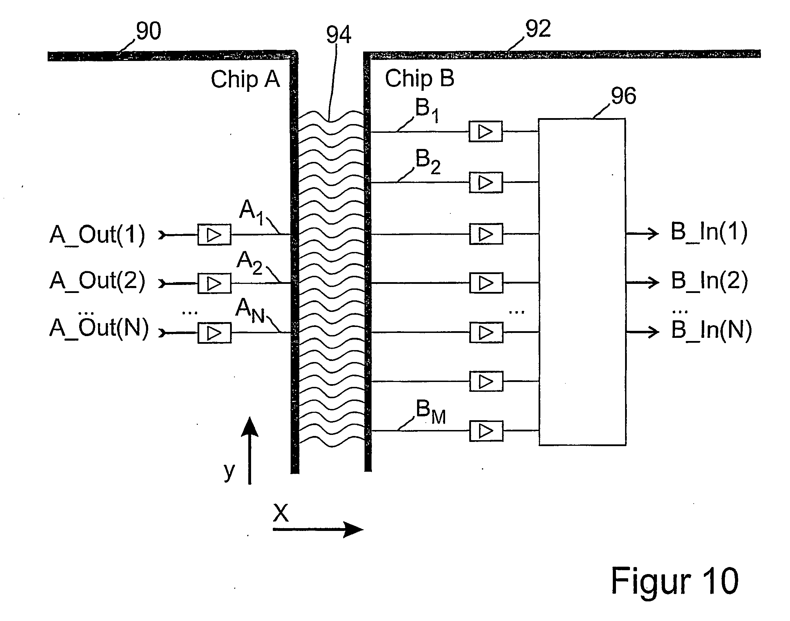

Figur 10 zeigt ein Blockschaltbild einer Chip-Anordnung mit zusätzlichen Kopplungselementen auf Seiten des Empfängers. Die Chip-Anordnung weist einen ersten Chip 90 und einen zweiten Chip 92 auf, die mit Hilfe eines Kopplungsbausteins 94 Signale durch kontaktlose Kopplung austauschen. Der Kopplungsbaustein 94 ist in Figur 10 nur schematisch durch Wellenlinien angedeutet. Diese haben nichts mit seiner tatsächlichen Ausgestaltung zu tun. Der erste Chip 90 weist eine geringere Anzahl erster Kopplungselemente $A_1$ bis $A_N$ auf. Dem stehen empfängerseitig auf dem Chip 92 Kopplungselemente $B_1$ bis $B_M$ gegenüber, wobei $M > N$. Chip 92 weist eine Auswahlschaltung 96 auf, die ausgebildet ist, zu ermitteln, über welche der Kopplungselemente $B_1$ bis $B_M$ die Signale der Kopplungselemente $A_0$ bis $A_N$ eintreffen. Diese N Signale werden von der Auswahlschaltung 96 parallel ausgegeben. Die Auswahlschaltung verwendet zur Auswahl der aktiven Kopplungselemente beispielsweise den anliegenden Signalverlauf über eine bestimmte Zeit, vergleicht diesen mit vordefinierten Mustern und entscheidet anhand des Vergleichsergebnisses, ob ein Kopplungselement aktiv ist oder nicht.

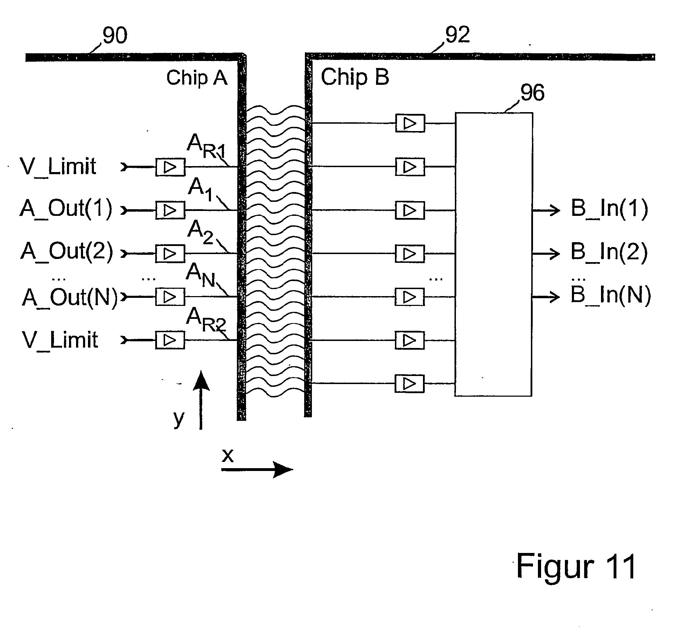

Figur 11 zeigt eine ähnliche Anordnung mit leichten Abwandlungen. Hier werden für entsprechende Elemente die gleichen Bezugszeichen gewählt wie in Figur 10. Der Chip 90, der die Senderseite der dargestellten Chip-Anordnung bildet, weist neben den Kopplungselementen $A_1$ bis $A_N$ zwei Randkopplungselemente $A_{R1}$ und $A_{R2}$ auf. Der Chip 90 ist ausgebildet, über die Kopplungselemente $A_{R1}$ und $A_{R2}$ bestimmte Erkennungssignale zu senden, um den Rand des Signalvektors $A_1$ bis AN eindeutig zu kennzeichnen. Das Erkennungssignal kann beispielsweise ein Pegelwechsel mit einer bestimmten Phasenlage relativ zu den Pegelwechseln aller anderen Kopplungselemente sein. In Figur 11 ist als solches Signal V_Limit gekennzeichnet. Die Auswahlschaltung 96 auf dem Chip 92 ist hier ausgebildet, die Randerkennungssignale zu detektieren. Empfängerseitige Kopplungselemente, die in y-Richtung zum Chip-Rand hin jenseits der Kopplungselemente liegen, über die die Randerkennungssignale empfangen werden, werden von der Auswahlschaltung 96 deaktiviert.

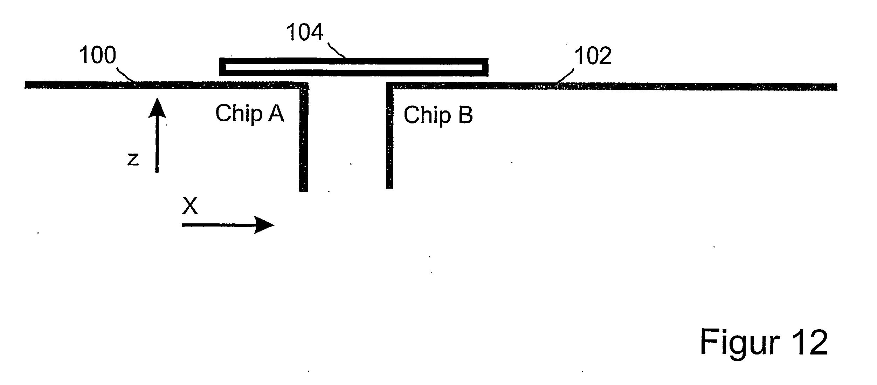

Die Figuren 12 bis 14 zeigen weitere unterschiedliche Ausführungsformen der erfindungsgemäßen Chip-Anordnung. Die in Figur 12 gezeigte Chip-Anordnung entspricht der der Figur 2. Ein erster Chip 100 und ein zweiter Chip 102 werden mit Hilfe eines Kopplungsbausteins 104, hier in Form einer Brücke für den kontaktlosen Signalaustausch miteinander gekoppelt. Die Brücke 104 liegt auf den Rändern der Chips 100 und 102 auf. Ein hier nicht dargestelltes Dielektrikum kann zur Erhöhung der kapazitiven Kopplung verwendet werden.

Die Anordnung der Figur 12 kann auch umgedreht werden, so dass die Brücke unterhalb der beiden Chips 100 und 102 liegt und die beiden Chips auf der Brücke aufliegen. Die Brücke 104 kann dabei auch einen Teil eines Trägers oder auch den gesamten Träger bilden, der sich über die gesamte Länge der Chips in x-Richtung der Figur 11 erstreckt. Signalschnittstellen müssen auf der Brücke jedoch nur dort vorgesehen sein, wo die Signalschnittstellen der Chips 100 und 102 miteinander gekoppelt werden sollen.

Bei der Anordnung der Figur 12 müssen die Chips in z-Richtung gut abgestimmt sein, damit die Brük-

ke in etwa plan aufliegen kann. Diese Anordnung ist im Übrigen vorteilhaft, wenn beide Chips weitere Anschlüsse aufweisen, die durch Bond-Drähte kontaktiert werden sollen.

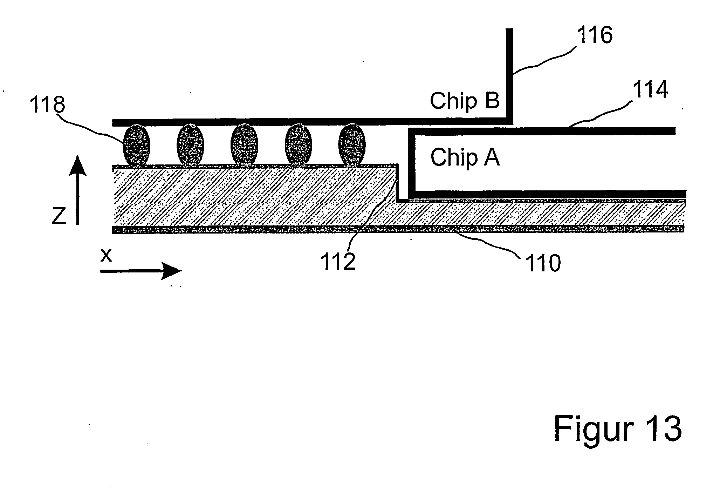

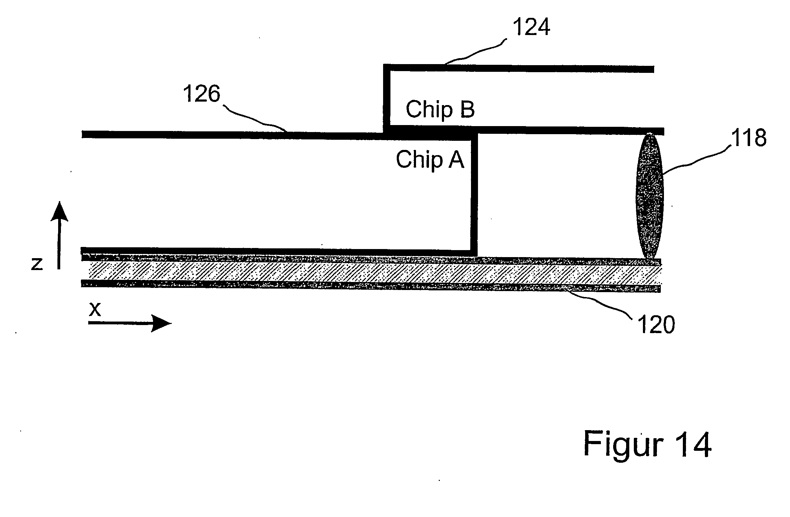

Die Figuren 13 und 14 zeigen alternative Ausbildungen einer erfindungsgemäßen Chip-Anordnung, bei der auf einen Kopplungsbaustein verzichtet werde kann. Hier ist jeweils einer der Chips mit einer zweiten Signalschnittstelle im Sinne der vorliegenden Erfindung ausgestattet. In der Chip-Anordnung der Figur 13 ist ein Träger 110 mit einer Stufe 112 vorgesehen, an der ein erster Chip 114 angelegt wird. Ein zweiter Chip 116 wird so auf den ersten Chip 114 aufgelegt, dass er nur im Bereich der Signalschnittstellen überdeckt. Die Signalschnittstelle des Chips 116 ist dem Chip 114 zugewandt auf der Unterseite vorgesehen. In x-Richtung erstreckt sich der aufliegende Chip 116 über die Stufe 112 hinaus und wird von sogenannten «Bumps" 118 gestützt und kontaktiert. Die Dicke dieser kontaktierenden Elemente 118 muss mit der Höhe des Chips 114 abgestimmt sein und die Stufe 112 berücksichtigen.

Figur 14 zeigt eine ähnliche Form der "flip-chip-Kopplung", bei der jedoch ein Träger 120 ohne Stufen vorgesehen ist. Bei dieser Anordnung müssen die kontaktierenden Elemente 118 allein die Höhenabstimmung in z-Richtung bewerkstelligen. Die vertikale Abstimmung ist einfach, wenn der oben liegende Chip 124 auf seiner Unterseite neben der erfindungsgemäßen Signalschnittstelle nur wenige elektrisch leitend zu kontaktierende Kontaktelemente hat. Dies kann zum Beispiel der Fall sein, wenn der oben liegende Chip 124 ein Speicherchip ist, der zusätzlich zur kontaktlosen Kopplung mit dem Chip 126 lediglich eine Spannungsversorgung benötigt. Da hier nur sehr wenige Kontaktelemente direkt zu kontaktieren sind, können diese mit sehr großer Fläche ausgeführt werden. Beispielsweise können sie einreihig so angeordnet und bemessen sein, dass sie gleichzeitig zum Höhenausgleich dienen, wie in Figur 14 angedeutet.

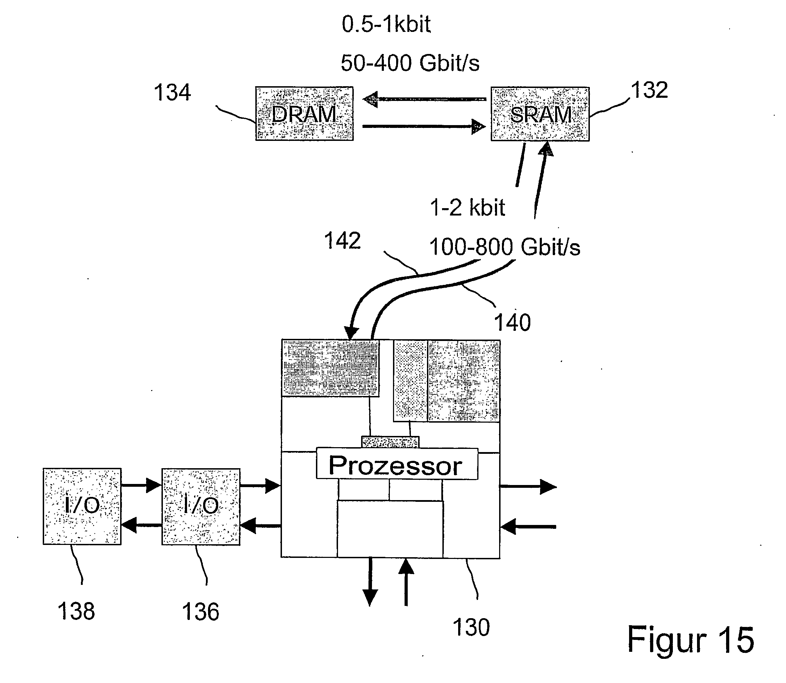

Figur 15 zeigt ein Anwendungsbeispiel der erfindungsgemäßen Chip-Anordnung. Die hier gezeigte Anordnung enthält einen Mikroprozessor 130, einen SRAM-Baustein 132, einen DRAM-Baustein 134 sowie Eingabe-/ Ausgabe-Bausteine 136 und 138. Mikroprozessor 130 und SRAM-Baustein 132 sind über eine erfindungsgemäße Signalschnittstelle miteinander verbunden. Dies ist vorliegend durch Pfeile 140 und 142 dargestellt. Auf diese Weise wird eine Schnittstelle zwischen dem Mikroprozessor 130 und dem schnellen Speicherbaustein 132 geschaffen, der damit von den Parametern Zugriffszeit und -größe her zwischen der Leistung eines internen Cache und eines externen Hauptspeichers auf einer Hauptplatine liegt. Im Vergleich zu bisherigen Lösungen, die nur Speicher "onchip" oder "onboard" haben, ist diese Lösung etwas teurer. Diese Kosten werden jedoch dann akzeptabel, wenn damit ein Engpass beseitigt wird, der die Rechenleistung des Gesamtsystems im wesentlichen Anwendungen auf einen Bruchteil absenkt. Dann entspricht die Wirkung des mit der erfindungsgemäßen Chip-Anordnung erzielten Speichererweiterung einer Vervielfachung der Taktrate des Prozessors.

Mit einer Etablierung der hier vorgeschlagenen hochdichten Schnittstelle in Form eines Standards kann auf längere Sicht sogar eine Kostensenkung bei gleichzeitiger Steigerung der Leistung erreicht werden, in dem ein großer Teil oder sogar der gesamte DRAM-Speicher in einer Chip-Anordnung der vorliegenden Erfindung gemäß in einem Modul integriert wird, und sich DRAM und SRAM die Bandbreite zum Prozessor teilen. Damit wird der Prozessor 130 bereits wesentliche Mengen Hauptspeicher im Modul mit enthalten.

Das hier vorgeschlagene System zur kontaktlosen Datenübertragung kann also erweitert werden, von einer Verbindung zwischen zwei Chips eines Moduls hin zu einer modular erweiterbaren Verbindungsstruktur einer Anzahl von Chips. Jeder Chip kann dabei Regenerierstufe und Treiber für die Weiterleitung der Signale zum nächsten Chip sein. Damit wächst zwar die Latenzzeit mit Abstand vom Prozessor. Angesichts der sehr hohen Datenrate und der geringen Latenz pro Stufe sind jedoch immer noch Vorteile zu erwarten. Die beim Stand der Technik eingesetzten aufwendigen Verfahren, eine hohe Datenrate zum DRAM-Baustein stabil zu erreichen, könnten dann entfallen oder vereinfacht werden. Denn in einem Modul nach der erfindungsgemäßen Chip-Anordnung sind die Verhältnisse auf Grund kurzer Entfernung und geringer parasitärer Kapazitäten entspannter. Höhere schaltungstechnische Anforderungen auf Grund einer erhöhten Dämpfung als bei direkt elektrisch leitenden Kontakten bereiten keine prinzipiellen Probleme. Sie sind auch mit Blick auf den Entwurfsaufwand und die dafür benötigte Chipfläche bei großen Stückzahlen von untergeordneter Bedeutung.

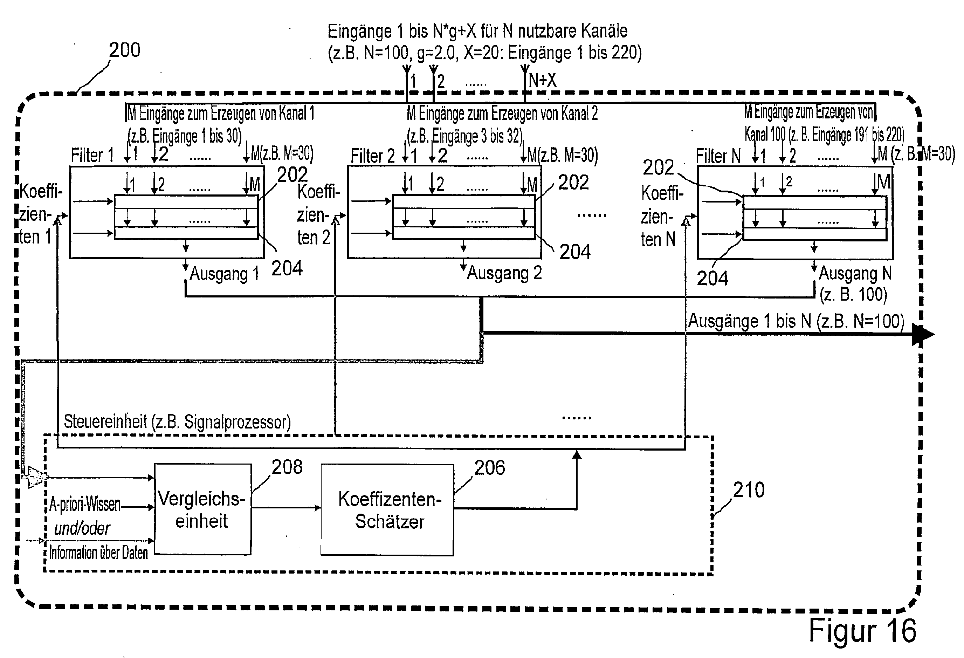

Figur 16 zeigt ein vereinfachtes Blockschaltbild einer empfängerseitigen Schaltung zur Signalaufbereitung. Das hier gezeigte Ausführungsbeispiel soll zur Übertragung N nutzbarer Kanäle dienen. Die Empfängerschaltung 200 der Figur 16 weist hierzu N*g+X Eingänge auf. Beispielsweise sind 220 Eingänge und entsprechend 220 Kopplungselemente vorgesehen, und senderseitig sind 100 Kopplungselemente vorgesehen. Der Faktor g beträgt in diesem Fall 2,0 und die Anzahl der seitlich überstehenden Kopplungselemente beträgt insgesamt X=20. Den Eingängen nachgeschaltet sind N Filter also beispielsweise 100 Filter. Jedes Filter hat eine Anzahl von Eingängen, die in Figur 16 mit M bezeichnet wird. M ist mindestens 1 und maximal gleich der Zahl der empfängerseitigen Kopplungselemente, und beträgt beispielsweise 30. Jedes Filter weist eine Filterbank 202 in Form einer "matched filter bank" auf, der eine Wichtungsschaltung 204 nachgeschaltet ist. Die Filterbank weist Steuereingänge auf, über die Filterkoeffizienten eingegeben werden können. Die Wichtungsschaltung 204 weist ebenfalls einen oder mehrere Steuereingänge auf, über die Wichtungsfaktoren programmiert werden können. Zur Bestimmung und Programmierung der Wichtungsfaktoren und Filterkoeffizienten ist ein Koeffizientenschätzer 206 vorgesehen. Der Koeffizientenschätzer 206 ist eingangsseitig mit einer Vergleichseinheit 208 verbunden. Beide zusammen sind in einer Steuereinheit 210 integriert. In einem ersten Beispiel eines Betriebsverfahrens der erfindungsgemäßen Chip-Anordnung wird zunächst eine Auswahl aktiver Eingänge, das heißt aktiver Kopplungselemente auf Empfängerseite getroffen. Dazu sei angenommen, dass für 100 zu nutzende Kanäle 220 Eingänge genutzt werden. Die Eingänge der Signalschnittstelle des Empfängers sind geometrisch doppelt so dicht angeordnet wie die senderseitigen Kopplungselemente. Beispielsweise sind die 100 Kopplungselemente des Senders in 10 μm-Raster angeordnet. Der Empfänger hat auf dieser Breite 200 Kopplungselemente im 5 μm-Raster. Darüber hinaus hat der Empfänger zusätzlich je 10, also 20 Kanäle an beiden Rändern der Signalschnittstelle, die grobe Versetzungen auffangen können. Für jeden der 100 Kanäle ist ein Filter vorhanden. Jedes von 100 Filtern der Empfangsschaltung hat M gleich 30 Eingänge. Die Filter verhalten sich in einem einfachen Beispiel wie ein reiner Umschalter. Das heißt: Die Filterbank reicht die Signale unverändert weiter. Die Wichtungsschaltung 204 jedoch kombiniert die Signale gewichtet. Dabei erhält im einfachsten Falle nur ein einziger Filtereingang das Gewicht 1,0. Alle anderen erhalten 0,0 und werden damit inaktiv. In diesem Fall führt die Empfängerschaltung lediglich eine räumliche, also geometrische, Auswahl der optimalen Empfangskanäle aus. Dabei stehen für einen zu nutzenden Kanal jeweils 30 Empfangskanäle zur Auswahl.

In einer leicht unschärferen Version dieses Betriebsverfahrens wird das gesamte Gewicht je nach Empfang auf den Eingängen auf 1 bis 3 Eingänge aufgeteilt. Zum Beispiel erhält ein Eingang a den Wichtungsfaktor 0,4, einen Eingang b den Wichtungsfaktor 0,4 und einen Eingang c) den Wichtungsfaktor 0,2. Die Eingänge a, b und c sind räumlich nebeneinander angeordnet. Auf diese Weise können unscharf verteilte Signale auf mehreren Eingängen erfasst werden. Aus einem reinen Umschalter wird ein Filter. Jedes solcher Filter hat M Eingänge, beispielsweise M=30. Die Eingänge des Empfängers werden möglichst gleichmäßig auf die Eingänge der Filter verteilt. Im Idealfall würde jedes Filter um $((N*g+X-M) / N)$ Eingänge weiter nach rechts versetzt sein als sein Vorgänger. Gegebenenfalls gebrochene Verhältnisse werden durch Rundung auf ganze Zahlen angepasst. Beispielsweise ist ein Filter um zwei Eingänge weiterversetzt statt rechnerisch um 1,9 Eingänge. In einer Einstellphase werden die 220 Eingänge abgefragt. Die Steuereinheit 210 sucht nach bekannten Eigenschaften der 100 Signale. Hierzu fragt sie die Eingänge nacheinander ab. Die Eingänge, in denen die bekannten Signaleigenschaften am deutlichsten zu finden sind, werden aktiviert durch Einstellen der Filterkoeffizienten. Zur Verbesserung des Empfangs können, wie oben beschrieben, mehrere benachbarte Eingänge für ein Signal aktiviert werden.

Nach der Einstellphase werden in der Arbeitsphase der Empfangsschaltung die Daten über die eingestellten Filter an die Ausgänge übertragen. Dabei kann die Qualität der Daten überwacht werden und ggf. während der Übertragung durch Anpassung der Filter- und Wichtungskoeffizienten nachgestellt werden. Alternativ kann eine neue Einstellphase vorgenommen werden.

In einem zweiten Beispiel eines Betriebsverfahrens bildet jedes der Filter einen "rake receiver". Das Signal wird durch Einzelfilter verändert und anschließend zusammengesetzt. In diesem Fall besteht die Filterbank aus M Filtern, die jeweils das Signal verändern. Der Ausgang jedes dieser M Einzel-Filter ist die gewichtete Summe einer Anzahl von zeitlich vorangegangenen Zuständen des Signals:

$$A(z) = \sum_{j=1}^{r} S(j) \cdot w(j,z),$$

wobei S(j) ein an einem Filtereingang in einem Zeitschritt j anliegendes Signal ist, r die Gesamtzahl der berücksichtigten Zeitschritte, w ein vom jeweiligen Zeitschritt j abhängiger Wichtungsfaktor und z ein das Filter bezeichnender Index.

Über die r Gewichte jedes Einzel-Filters wird dessen einzelne Filter-Charakteristik eingestellt. Das Signal wird demnach in seinen Frequenzanteilen verändert. Die technisch übliche Variante hierfür ist ein Schieberegister der Länger r, das mit r Multiplizierern und eine Addierer verbunden ist. Jedem Verzögerungselement der Verzögerungskette ist ein Multiplizierer und ein weiteres Verzögerungselement parallel nachgeschaltet. Lediglich das letzte Verzögerungsglied ist allein mit einem Multiplizierer verbunden. Die Ausgänge der Multiplizierer sind mit parallelen Eingängen eines Addierers verbunden. Die Wichtungsschaltung kombiniert die M Signale gewichtet. Hierbei können mehrere Filter-Eingänge ein Gewicht ungleich 0 erhalten. Die Eingänge des Empfängers werden wie oben schon beschrieben auf die Eingänge der Filter verteilt.

In einer Einstellphase werden die 220 Eingänge abgefragt. Die Steuereinheit sucht nach bekannten Eigenschaften der 100 Signale. Hierzu fragt sie der Reihe nach die 220 Eingänge ab. Anschließend werden die Filterkoeffizienten und Wichtungsfaktoren geschätzt. Von dieser Anfangsschätzung ausgehend werden diese Koeffizienten und Faktoren weiter optimiert. Hierbei handelt es sich um ein Optimierungsproblem mit sehr vielen Freiheitsgraden. Zur Bewertung der Qualität des Signals können Korrelatoren in der Vergleichseinheit 208 vorgesehen sein, die das Signal mit einem bekannten Muster vergleichen. Die Ausgabe der Korrelatoren ist eine Zahl, die einem Maß für die Ähnlichkeit eines empfangenen Signals mit einem vorgegebenen Muster entspricht. Algorithmen wie beispielsweise ein "least-mean-square-algorithmus" können genutzt werden, um die Koeffizienten in der Schätzeinheit 206 schrittweise zu optimieren.

In der Arbeitsphase werden die empfangenen Signale über die eingestellten Filter an die Ausgänge übertragen. Während des Betriebes kann wie schon oben beschrieben die Qualität der Daten überwacht werden und ggf. während der Übertragung die Koeffizienten nachgestellt werden. Alternativ kann eine neue Einstellphase vorgenommen werden.

In der Praxis bietet es sich an, die beiden beschriebenen Betriebsverfahren gemischt zu verwenden. Ein reines Signalverarbeitungsverfahren wie zuletzt beschrieben dürfte nicht praktikabel sein. Dagegen könnte eine reine Auswahl von Kopplungselementen in der Empfangsschaltung ohne ein nachträgliches Entmischen der Signale möglich sein. Zur Optimierung des Signal-Rauschabstandes bietet es sich jedoch an, mehrere Eingänge für einen Datenkanal zu nutzen.

**Patentansprüche**

1. Chip-Anordnung mit einem ersten Chip (10), der mindestens eine erste Signalschnittstelle (18) mit längs einer ersten Linie (11) in einer ersten Anzahldichte angeordneten ersten Kopplungselementen (20 bis 30) aufweist, und mit mindestens einem zweiten Chip (12), der mindestens eine zweite Signalschnittstelle (32) mit längs einer zweiten Linie (13) in einer zweiten Anzahldichte angeordneten zweiten Kopplungselementen (34, 36) aufweist,

   - bei der die erste Signalschnittstelle (18) längs einer Kante des ersten Chips (10) und die zweite Signalschnittstelle (32) längs einer Kante des zweiten Chips (12) vorgesehen ist,
   - bei der die ersten und zweiten Kopplungselemente (20 bis 30, 34, 36) ausgebildet sind, eine kontaktlose Signalübertragung zwischen der ersten und der zweiten Signalschnittstelle (18, 32) zu ermöglichen,
   - bei der der erste und der zweite Chip (10, 12) relativ zueinander so angeordnet sind, dass Kopplungselemente (20 bis 30, 34, 36) der ersten und der zweiten Signalschnittstelle (18, 32) miteinander kontaktlos Signale übertragen können, wobei die genannten Kanten des ersten und zweiten Chips (10, 12) einander zugewandt angeordnet sind,

   **dadurch gekennzeichnet, dass**

   - die Längserstreckung (11; 13) mindestens einer der Signalschnittstellen (18; 32) längs der ihr zugeordneten Linie größer ist als die Länge der Überlappung (15) beider Längserstreckungen (11; 13), wobei diese Überlappung (15) die Strecke ist, die die Projektion der ersten Längserstreckung (11) auf die zweite Längserstreckung (13) gemeinsam hat mit der zweiten Längserstreckung (13),
   - und dass eine der Signalschnittstellen (18; 32) eine größere Anzahldichte an Kopplungselementen (20 bis 30; 34, 36) aufweist als die andere.

2. Chip-Anordnung mit einem ersten Chip (10), der mindestens eine erste Signalschnittstelle (18) mit längs einer ersten Linie (11) in einer ersten Anzahldichte angeordneten ersten Kopplungselementen (20 bis 30) aufweist, und mit mindestens einem zweiten Chip (12), der mindestens eine zweite Signalschnittstelle (32) mit längs einer zweiten Linie (13) in einer zweiten Anzahldichte angeordneten zweiten Kopplungselementen (34, 36) aufweist,

   - bei der die erste Signalschnittstelle (18) längs einer Kante des ersten Chips (10) und die zweite Signalschnittstelle (32) längs einer Kante des zweiten Chips (12) vorgesehen ist,
   - bei der die ersten, zweiten und dritten und vierten Kopplungselemente (20 bis 30, 34, 36, 45, 46) ausgebildet sind, eine kontaktlose Signalübertragung zwischen der ersten und der zweiten Signalschnittstelle (18, 32) zu ermöglichen,

   **gekennzeichnet durch** einen Kopplungsbaustein (38), der auf einem Substrat eine Kopplungseinheit mit längs einer dritten Linie in einer dritten Anzahldichte angeordneten dritten Kopplungselementen (45) sowie mit längs einer vierten Linie in einer vierten Anzahldichte angeordneten vierten Kopplungselementen (46) aufweist, wobei die dritten Kopplungselemente (45) jeweils mit den vierten Kopplungselementen (46) elektrisch leitend verbunden sind,

   - bei der der erste und der zweite Chip (10;12) sowie der Kopplungsbaustein (38) so zueinander angeordnet sind, dass dritte Kopplungselemente (45) der Kopplungseinheit und erste Kopplungselemente (20 bis 30) der ersten Signalschnittstelle (18) sowie vierte Kopplungselemente (46) der Kopplungseinheit und zweite Kopplungselemente (34, 36) der zweiten Signalschnittstelle (32) jeweils miteinander kontaktlos Signale übertragen können, wobei die genannten Kanten des ersten und zweiten Chips (10; 12) einander zugewandt angeordnet sind,
   - bei der für die Längserstreckungen jeweils der ersten und dritten Kopplungselemente (20 bis 30, 45) in Abstandsrichtung der Kopplungselemente (20 bis 30, 45) längs der ihr zugeordneten Linie gilt, dass mindestens eine der Längserstreckungen größer ist als die Länge der Überlappung beider Längserstreckungen,
   - bei der für die Längserstreckungen jeweils der zweiten und vierten Kopplungselemente (34, 36, 46) in Abstandsrichtung der Kopplungselemente (34, 36, 46) längs der ihr zugeordneten
Linie gilt, dass mindestens eine der Längserstreckungen größer ist als die Länge der Überlappung beider Längserstrekkungen,
- und bei der der Kopplungsbaustein (38) eine
größere Anzahldichte an Kopplungselementen
aufweist als die erste oder die zweite Signalschnittstelle (18 oder 32) oder als die erste und
die zweite Signalschnittstelle (18 und 32).

3. Chip-Anordnung nach Anspruch 1 oder 2, bei der
die ersten, zweiten und gegebenenfalls dritten und
vierten Kopplungselemente (20 bis 30, 34, 36, 45,
46) ausgebildet sind, die kontaktlose Signalübertragung mit Hilfe elektromagnetischer, alternativ kapazitiver, alternativ induktiver, alternativ induktiver und
kapazitiver Kopplung zwischen jeweils einem ersten
und einem oder mehreren zweiten Kopplungselementen (20 bis 30 und 34, 36) zu ermöglichen.

4. Chip-Anordnung nach Anspruch 1, bei der die Längserstreckung der derjenigen Signalschnittstelle (18,
32) größer ist, welche die höhere Anzahldichte aufweist.

5. Chip-Anordnung nach Anspruch 1, bei der der zweite
Chip (116, 124) zumindest teilweise auf dem ersten
Chip (114, 126) aufliegt.

6. Chip-Anordnung nach Anspruch 2, bei der der erste
und zweite Chip (70, 72) auf einer Trägerfläche nebeneinander angeordnet sind.

7. Chip-Anordnung nach Anspruch 5 oder 6, bei der
ein Füllstoff mit hoher Dielektrizitätskonstante zwischen der ersten und der zweiten Signalschnittstelle
(18 und 32) oder gegebenenfalls zwischen der ersten Signalschnittstelle (18) und der Kopplungseinheit sowie zwischen der zweiten Signalschnittstelle
(32) und der Kopplungseinheit angeordnet ist.

8. Chip-Anordnung nach einem der vorstehenden Ansprüche, bei der die Anzahl N2 der Kopplungselemente (20 bis 30; 34, 36) der Signalschnittstelle (18;
32) mit der höheren Anzahldichte zur Anzahl N1 der
Kopplungselemente (20 bis 30; 34, 36) der Signalschnittstelle (18; 32) mit der geringeren Anzahldichte
im Verhältnis N2=g*N1+X steht, wobei g eine Zahl
größer 1 und X die Anzahl der Kopplungselemente
(20 bis 30; 34, 36; 45; 46) ist, die in den überschießenden Längsabschnitten der Signalschnittstelle
(18; 32) oder gegebenenfalls der Kopplungseinheit
liegen.

9. Chip-Anordnung nach einem der vorstehenden Ansprüche, bei der die Signalschnittstelle (18; 32) desjenigen Chips, welcher im Signalfluss zwischen dem ersten und dem zweiten Chip einen Empfänger bildet
und nachfolgend als Empfänger-Chip (200) bezeichnet wird, Kopplungselemente mit einer höheren Anzahldichte aufweist.

10. Chip-Anordnung nach Anspruch 9, mit einer der Signalschnittstelle (18; 32) nachgeschalteten Filterschaltung auf dem Empfänger-Chip (200), die ausgebildet ist, von senderseitigen Kopplungselementen ausgesandte Signale anhand der von den empfängerseitigen Kopplungselementen empfangenen
Signale zu rekonstruieren.

11. Chip-Anordnung nach Anspruch 10, bei der die Filterschaltung eine Anzahl Wichtungselemente (204)
aufweist, die jeweils ausgebildet sind, von mehreren
empfängerseitigen Kopplungselementen empfangene Signale mit veränderbaren Wichtungsfaktoren
zu multiplizieren und die so gewichteten Signale zu
addieren.

12. Chip-Anordnung nach Anspruch 11, bei der empfängerseitige Kopplungselemente mit mehreren Wichtungselementen (204) verbunden sind.

13. Chip-Anordnung nach Anspruch 11, bei der die Anzahl der Wichtungselemente (204) gleich der Anzahl
der senderseitig vorgesehenen Kopplungselemente
ist.

14. Chip-Anordnung nach Anspruch 11, 12 oder 13, mit
einer mit den Kopplungselementen und der Filterschaltung verbundenen Steuereinheit (210), die
ausgebildet ist, die Wichtungsfaktoren zu bestimmen.

15. Chip-Anordnung nach Anspruch 14, bei der die Steuereinheit (210) ausgebildet ist, für jedes Wichtungselement (204) die an den mit dem Filter verbundenen, empfängerseitigen Kopplungselementen empfangenen Signale jeweils mit einem vordefinierten
Signalmuster zu vergleichen und den Kopplungselementen jeweils einen vom Vergleichsergebnis abhängigen Wichtungsfaktor zuzuordnen.

16. Chip-Anordnung nach Anspruch 15, bei der die Steuereinheit (210) ausgebildet ist, pro Wichtungselement (204) maximal einem bis drei Kopplungselementen einen von Null verschiedenen Wichtungsfaktor zuzuordnen, derart, dass die Summe aller
Wichtungsfaktoren 1 beträgt.

17. Chip-Anordnung nach einem der Ansprüche 10 bis
16, bei der die Filterschaltung zusätzlich oder alternativ eine Anzahl Filterbänke (202) aufweist, wobei
jede Filterbank (202) eingangsseitig mit einer Anzahl
Kopplungselementen verbunden ist.

**18.** Chip-Anordnung nach Anspruch 17, bei der jede Filterbank (202) eine Anzahl Filter aufweist und jedes Filter eingangsseitig mit einem Kopplungselement verbunden ist.

**19.** Chip-Anordnung nach Anspruch 18, bei der jedes Filter ausgebildet ist, ein Ausgangssignal abzugeben, das von einer gewichteten Summe des aktuellen und einer Anzahl zeitlich vorangegangener Signale an seinem Eingang abhängt.

**20.** Chip-Anordnung nach Anspruch 17, bei der jedes Filter ausgebildet ist, sein Ausgangssignal A entsprechend folgender Formel zu bestimmen:

$$A(z) = \sum_{j=1}^{r} S(j) \cdot w(j, z) \,,$$

wobei S(j) ein an einem Filtereingang in einem Zeitschritt j anliegendes Signal ist, r die Gesamtzahl der berücksichtigten Zeitschritte, w ein vom jeweiligen Zeitschritt j abhängiger Wichtungsfaktor und z ein das Filter bezeichnender Index.

**21.** Chip-Anordnung nach Anspruch 20, bei der das Filter eine SignalVerzögerungskette mit r Verzögerungselementen, r Multiplizierer und einen Addierer aufweist, wobei jedem bis auf das letzte Verzögerungselement parallel ein Multiplizierer und ein Verzögerungselement nachgeschaltet sind, dem letzten Verzögerungsglied allein ein Multiplizierer nachgeschaltet ist, und die Ausgänge der Multiplizierer mit parallelen Eingängen des Summierers verbunden sind.

**22.** Chip-Anordnung nach Anspruch 18 bis 21, bei der jede Filterbank (202) eine Wichtungseinheit (204) aufweist, die ausgebildet ist, von den Filtern der jeweiligen Filterbank (202) empfangene Signale mit veränderbaren Wichtungsfaktoren zu multiplizieren und die so gewichteten Signale zu addieren.

**23.** Chip-Anordnung nach einem der Ansprüche 17 bis 22, mit einer mit den Filterbänken (202) verbundenen Steuereinheit (210), die ausgebildet ist, in einer Trainingsphase die an den empfängerseitigen Kopplungselementen anliegenden Signale einer Korrelation mit einem oder mehreren bekannten Signalmustern zu unterziehen und anhand des Korrelationsergebnisses die Wichtungsfaktoren der Filter und der Wichtungsschaltung (204) zu bestimmen.

**24.** Chip-Anordnung nach einem der vorstehenden Ansprüche, bei der derjenige Chip (90), dessen Signalschnittstelle eine geringere Anzahl an Kopplungselementen, je ein Randkopplungselement (A$_{R1}$, A$_{R2}$) an den Enden seiner Signalschnittstelle aufweist und ausgebildet ist, an die Randkopplungselemente (A$_{R1}$, A$_{R2}$) ein vordefiniertes Randsignal anzulegen.

**25.** Chip-Anordnung nach Anspruch 1 oder 2, bei der derjenige Chip, der im Signalfluss zwischen dem ersten und dem zweiten Chip einen Sender bildet, eine Sendeschaltung aufweist, die komplementäre CMOS-Transistoren aufweist.

**26.** Chip-Anordnung nach Anspruch 1 oder 2, bei der der eine Chip ein Mikroprozessor (130) und der andere Chip ein Speicherchip (132) ist.

**27.** Chip-Anordnung nach Anspruch 1, mit einem dritten Chip, der mit dem ersten oder dem zweiten Chip entsprechend der in Anspruch 1 oder Anspruch 2 beschriebenen Weise zur Signalübertragung gekoppelt ist, derart, dass der erste bzw. zweite Chip für die Kopplung mit dem dritten Chip wie der erste Chip des Anspruchs 1 oder 2 ausgebildet ist und der dritte Chip für die Kopplung mit dem ersten Chip wie der zweite Chip des Anspruchs 1 oder 2 ausgebildet ist, oder umgekehrt, wobei der erste oder der zweite Chip eine weitere Signalschnittstelle mit den Merkmalen der ersten Signalschnittstelle oder der zweiten Signalschnittstelle aufweist.

**28.** Chip-Anordnung nach Anspruch 2, mit einem dritten Chip, der mit dem ersten oder dem zweiten Chip entsprechend der in Anspruch 1 oder 2 beschriebenen Weise zur Signalübertragung ausgebildet und angeordnet ist, wobei der erste oder der zweite Chip eine weitere Signalschnittstelle mit den Merkmalen der ersten Signalschnittstelle oder der zweiten Signalschnittstelle aufweist.

**29.** Verfahren zur Herstellung einer Chip-Anordnung nach Anspruch 2, mit den Schritten:

a) Positionierung des ersten Chips auf einem Träger,
b) Positionierung des zweiten Chips relativ zum ersten Chip auf dem Träger,
c) Positionieren eines Kopplungsbausteins zur Herstellung einer kontaktlosen Kopplung für die Signalübertragung zwischen dem ersten und zweiten Chip.

**30.** Verfahren nach Anspruch 29, mit einem zusätzlichen Schritt des Ermittelns aktiver Kopplungselemente auf dem Chip mit einer Überzahl von Kopplungselementen gegenüber dem anderen Chip derart, dass anhand vordefinierter Signalkriterien diejenigen Kopplungselemente ermittelt werden, die ein empfangenes Signal ausgeben.

## Claims

1. Chip arrangement having a first chip (10) which comprises at least one first signal interface (18) with first coupling elements (20 to 30) arranged along a first line (11) in a first number density, and having at least one second chip (12) which comprises at least one second signal interface (32) with second coupling elements (34, 36) arranged along a second line (13) in a second number density,

   - wherein the first signal interface (18) is provided along an edge of the first chip (10) and the second signal interface (32) is provided along an edge of the second chip (12),
   - wherein the first and second coupling elements (20 to 30, 34, 36) are constructed to enable contactless signal transmission between the first and second signal interface (18, 32),
   - wherein the first and the second chip (10, 12) are arranged relative to one another such that coupling elements (20 to 30, 34, 36) of the first and second signal interface (18, 32) are able to transmit signals to one another in contactless manner, the said edges of the first and second chips (10, 12) being arranged facing one another,

   **characterised in that**

   - the longitudinal extent (11; 13) of at least one of the signal interfaces (18; 32) along the line associated therewith is greater than the length of the overlap (15) between the two longitudinal extents (11; 13), this overlap (15) being the distance that the projection of the first longitudinal extent (11) onto the second longitudinal extent (13) has in common with the second longitudinal extent (13),
   - and **in that** one of the signal interfaces (18; 32) has a greater number density of coupling elements (20 to 30; 34, 36) than the other.

2. Chip arrangement having a first chip (10) which comprises at least one first signal interface (18) with first coupling elements (20 to 30) arranged along a first line (11) in a first number density, and having at least one second chip (12) which comprises at least one second signal interface (32) with second coupling elements (34, 36) arranged along a second line (11) in a second number density,

   - wherein the first signal interface (18) is provided along an edge of the first chip (10) and the second signal interface (32) is provided along an edge of the second chip (12),
   - wherein the first, second, third and fourth coupling elements (20 to 30, 34, 36, 45, 46) are constructed to enable contactless signal transmission between the first and second signal interface (18, 32),

**characterised by** a coupling component (38) which comprises, on a substrate, a coupling unit having third coupling elements (45) arranged along a third line in a third number density and having fourth coupling elements (46) arranged along a fourth line in a fourth number density, the third coupling elements (45) being connected to the fourth coupling elements (46) in electrically conductive manner,

   - wherein the first and the second chip (10; 12) and the coupling component (38) are arranged relative to one another such that third coupling elements (45) of the coupling unit and first coupling elements (20 to 30) of the first signal interface (18), and fourth coupling elements (46) of the coupling unit and second coupling elements (34, 36) of the second signal interface (32), are able to transmit signals to one another in contactless manner, the said edges of the first and second chips (10; 12) being arranged facing one another,
   - wherein for the longitudinal extents of each of the first and third coupling elements (20 to 30, 45) in the direction of spacing of the coupling elements (20 to 30, 45) along the line associated therewith, at least one of the longitudinal extents is greater than the length of the overlap of the two longitudinal extents,
   - wherein for the longitudinal extents of each of the second and fourth coupling elements (34, 36, 46) in the direction of spacing of the coupling elements (34, 36, 46) along the line associated therewith, at least one of the longitudinal extents is greater than the length of the overlap of the two longitudinal extents,
   - and wherein the coupling component (38) has a greater number density of coupling elements than the first or the second signal interface (18 or 32) or than the first and the second signal interface (18 and 32).

3. Chip arrangement according to claim 1 or 2, wherein the first, second and optionally third and fourth coupling elements (20 to 30, 34, 36, 45, 46) are constructed to enable contactless signal transmission by means of electromagnetic, alternatively capacitive, alternatively inductive, alternatively inductive and capacitive coupling between in each case a first and one or more second coupling elements (20 to 30 and 34, 36).

4. Chip arrangement according to claim 1, wherein the longitudinal extent of the signal interface (18, 32) that has the higher number density is greater.

**5.** Chip arrangement according to claim 1, wherein the second chip (116, 124) is at least partly supported on the first chip (114, 126).

**6.** Chip arrangement according to claim 2, wherein the first and second chip (70, 72) are arranged side by side on a carrier surface.

**7.** Chip arrangement according to claim 5 or 6, wherein a filler with a high dielectric constant is arranged between the first and the second signal interface (18 and 32) or optionally between the first signal interface (18) and the coupling unit and between the second signal interface (32) and the coupling unit.

**8.** Chip arrangement according to one of the preceding claims, wherein the number N2 of coupling elements (20 to 30; 34, 36) of the signal interface (18; 32) with the higher number density in relation to the number N1 of coupling elements (20 to 30; 34, 36) of the signal interface (18; 32) with the lower number density is in the ratio N2=g*N1X, where g is a number greater than 1 and X is the number of coupling elements (20 to 30; 34, 36; 45; 46) which are located in the overshooting longitudinal sections of the signal interface (18; 32) or optionally of the coupling unit.

**9.** Chip arrangement according to one of the preceding claims, wherein the signal interface (18; 32) of the chip that forms a receiver in the signal flow between the first and second chip and is hereinafter designated the receiver chip (200) comprises coupling elements with a higher number density.

**10.** Chip arrangement according to claim 9, with a filter circuit on the receiver chip (200) downstream of the signal interface (18; 32), said filter circuit being designed to reconstruct signals sent from coupling elements on the transmitter side by means of the signals received from the couplings elements on the receiver side.

**11.** Chip arrangement according to claim 10, wherein the filter circuit comprises a number of weighting elements (204) which are constructed to as to multiply signals received from a plurality of coupling elements on the receiver side by variable weighting factors and add the signals thus weighted.

**12.** Chip arrangement according to claim 11, wherein coupling elements on the receiver side are connected to a plurality of weighting elements (204).

**13.** Chip arrangement according to claim 11, wherein the number of weighting elements (204) is equal to the number of coupling elements provided on the transmitter side.

**14.** Chip arrangement according to claim 11, 12 or 13, having a control unit (210) connected to the coupling elements and the filter circuit, which is constructed so as to determine the weighting factors.

**15.** Chip arrangement according to claim 14, wherein the control unit (210) is constructed so as to compare the signals received at the coupling elements on the receiver side connected to the filter with a predefined signal pattern, for each weighting element (204), and to assign to each of the coupling elements a weighting factor that is dependent on the results of the comparison.

**16.** Chip arrangement according to claim 15, wherein the control unit (210) is constructed so as to assign a weighting factor other than zero to at most one to three coupling elements, for each weighting element (204), such that the sum of all the weighting factors is 1.

**17.** Chip arrangement according to one of claims 10 to 16, wherein the filter circuit additionally or alternatively comprises a number of filter banks (202), each filter bank (202) being connected on the input side to a number of coupling elements.

**18.** Chip arrangement according to claim 17, wherein each filter bank (202) has a number of filters and each filter is connected on the input side to a coupling element.

**19.** Chip arrangement according to claim 18, wherein each filter is constructed to emit an output signal that is dependent on a weighted sum of the signals currently at its input and a number of signals previously present at its input.

**20.** Chip arrangement according to claim 17, wherein each filter is constructed so as to determine its output signal A according to the following formula:#

$$A(z) = \sum_{j=1}^{r} S(j) \cdot w(j, z),$$

where S(j) is a signal present at a filter input in a time step j, r is the total number of time steps under consideration, w is a weighting factor depending on the respective time step j and z is an index that designates the filter.

**21.** Chip arrangement according to claim 20, wherein the filter comprises a signal delay chain with r delaying elements, r multipliers and an adder, each delaying element apart from the last one having a multiplier and a delaying element connected downstream thereof, the last delaying member having only a multiplier connected downstream thereof, and the outputs of the multipliers being connected to parallel inputs of the adder.

22. Chip arrangement according to claims 18 to 21, wherein each filter bank (202) comprises a weighting unit (204) which is constructed to multiply signals received from the filters of the respective filter bank (202) by variable weighting factors and to add the signals thus weighted.

23. Chip arrangement according to one of claims 17 to 22, having a control unit (210) connected to the filter banks (202), which is constructed to subject the signals present at the coupling elements on the receiver side to correlation with one or more known signal patterns in a training phase and, using the results of the correlation, to determine the weighting factors of the filters and the weighting circuit (204).

24. Chip arrangement according to one of the preceding claims, wherein the chip (90) the signal interface of which has a smaller number of couplings elements comprises an edge coupling element ($A_{R1}$, $A_{R2}$) at the ends of its signal interface and is constructed to apply a predefined edge signal to the edge coupling elements ($A_{R1}$, $A_{R2}$).

25. Chip arrangement according to claim 1 or 2, wherein each chip that forms a transmitter in the signal flow between the first and second chip comprises a transmitter circuit that has complementary CMOS transistors.

26. Chip arrangement according to claim 1 or 2, wherein one chip is a microprocessor (130) and the other chip is a memory chip (132).

27. Chip arrangement according to claim 1, having a third chip that is coupled to the first or second chip in the manner described in claim 1 or claim 2 for signal transmission, such that the first or second chip is designed for coupling to the third chip like the first chip in claim 1 or 2 and the third chip is designed for coupling to the first chip like the second chip in claim 1 or 2, or *vice versa,* the first or second chip having an additional signal interface with the features of the first signal interface or the second signal interface.

28. Chip arrangement according to claim 2, having a third chip which is constructed and arranged for signal transmission with the first or second chip in the manner described in claim 1 or 2, the first or second chip having an additional signal interface with the features of the first signal interface or the second signal interface.

29. Method of producing a chip arrangement according to claim 2, comprising the steps of:

   a) positioning the first chip on a carrier,
   b) positioning the second chip relative to the first chip on the carrier,
   c) positioning a coupling component for producing a contactless coupling for the signal transmission between the first and second chip.

30. Method according to claim 29, with an additional step of detecting active coupling elements on the chip that have a greater number of coupling elements than the other chip, such that the coupling elements that emit a received signal are ascertained by means of predefined signal criteria.

## Revendications

1. Système de puces avec une première puce (10), laquelle présente au moins une première interface de transmission de signaux (18) avec des premiers éléments d'accouplement (20 à 30) disposés le long d'une première ligne (11) selon une première densité volumique, et avec au moins une deuxième puce (12), laquelle présente au moins une deuxième interface de transmission (32) avec des deuxièmes éléments d'accouplement (34, 36) disposés le long d'une deuxième ligne (13) selon une deuxième densité volumique,

   - dans lequel la première interface de transmission de signaux (18) est prévue le long d'une arête de la première puce (10) et la deuxième interface de transmission de signaux (32) est prévue le long d'une arête de la deuxième puce (12),
   - dans lequel les premiers et deuxièmes éléments d'accouplement (20 à 30 ; 34, 36) sont réalisés de manière à permettre une transmission sans contact des signaux entre la première interface de transmission de signaux et la deuxième interface de transmission de signaux (18, 32),
   - dans lequel la première et la deuxième puce (10, 12) sont disposées l'une par rapport à l'autre de manière à ce que des éléments d'accouplement (20 à 30, 34, 36) de la première et de la deuxième interface de transmission de signaux (18, 32) puissent transmettre des signaux sans contact, les arêtes mentionnées de la première et de la deuxième puce (10, 12) étant disposées de manière à se faire face,

   **caractérisé en ce que**

   - l'étendue longitudinale (11 ; 13) de l'une au moins des interfaces de transmission de signaux (18 ; 32), le long de la ligne qui lui est associée, est d'une longueur supérieure à la longueur de la superposition (15) des deux étendues longitudinales (11 ; 13), cette superposition (15) correspondant à l'étendue ayant en commun la projection de la première étendue longitudinale (11) sur la deuxième étendue longitudinale (13) avec la deuxième étendue longitudinale (13),

- et **en ce que** l'une des interfaces de transmission de signaux (18 ; 32) présente une densité volumique plus importante d'éléments d'accouplement (20 à 30 ; 34, 36) que l'autre interface.

**2.** Système de puces avec une première puce (10), laquelle présente au moins une première interface de transmission de signaux (18) avec des premiers éléments d'accouplement (20 à 30) disposés le long d'une première ligne (11) selon une première densité volumique, et avec au moins une deuxième puce (12) laquelle présente au moins une deuxième interface de transmission de signaux (32) avec des deuxièmes éléments d'accouplement (34, 36) disposés le long d'une deuxième ligne (13) selon une deuxième densité volumique,

- dans lequel la première interface de transmission de signaux (18) est prévue le long d'une arête de la première puce (10) et la deuxième interface de transmission de signaux (32) est prévue le long d'une arête de la deuxième puce (12),

- dans lequel les premiers, deuxièmes et troisièmes et quatrièmes éléments d'accouplement (20 à 30, 34, 36, 45, 46) sont réalisés de manière à permettre une transmission sans contact des signaux entre la première interface de transmission de signaux et la deuxième interface de transmission de signaux (18, 32),

**caractérisé par** un module de couplage (38), lequel présente, sur un substrat, une unité de couplage avec des troisièmes éléments d'accouplement (45) disposés le long d'une troisième ligne selon une troisième densité volumique ainsi qu'avec des quatrièmes éléments d'accouplement (46) disposés le long d'une quatrième ligne selon une quatrième densité volumique, les troisièmes éléments d'accouplement (45) étant respectivement connectés de manière électroconductrice aux quatrièmes éléments d'accouplement (46),

- dans lequel la première et la deuxième puce (10 ; 12) ainsi que le module de couplage (38) sont disposés les uns par rapport aux autres de manière à ce que des troisièmes éléments d'accouplement (45) de l'unité d'accouplement et des premiers éléments d'accouplement (20 à 30) de la première interface de transmission de signaux (18) ainsi que des quatrièmes éléments d'accouplement (46) de l'unité d'accouplement et des deuxièmes éléments d'accouplement (34, 36) de la deuxième interface de transmission de signaux (32) puissent respectivement transmettre des signaux de manière sans contact, les arêtes mentionnées des première et deuxième puces (10 ; 12) étant disposées de manière à se faire face,

- dans lequel, pour les étendues longitudinale respectivement des premiers et troisièmes éléments d'accouplement (20 à 30, 45) en direction d'écartement des éléments d'accouplement (20 à 30, 45) le long de la ligne qui leur est associée, s'applique le fait qu'au moins une des étendues longitudinales est supérieure à la longueur de la superposition des deux étendues longitudinales,

- dans lequel, pour les étendues longitudinales respectivement des deuxièmes et quatrièmes éléments d'accouplement (34, 36, 46) en direction d'écartement des éléments d'accouplement (34, 36, 46) le long de la ligne qui leur est associée, s'applique le fait qu'au moins une des étendues longitudinales est supérieure à la longueur de la superposition des deux étendues longitudinales,

- et dans lequel le module de couplage (38) présente une densité volumique plus importante d'éléments d'accouplements que la première ou la deuxième interface de transmission de signaux (18 ou 32) ou que la première et la deuxième interface de transmission de signaux (18 et 32).

**3.** Système de puces selon la revendication 1 ou la revendication 2, dans lequel les premiers, deuxièmes et le cas échéant également les troisièmes et quatrièmes éléments d'accouplement (20 à 30, 34, 36, 45, 46) sont réalisés de manière à permettre la transmission sans contact des signaux à l'aide d'un couplage électromagnétique, en variante capacitif, en variante inductif, en variante inductif et capacitif, respectivement entre un premier et un ou plusieurs deuxièmes éléments d'accouplement (20 à 30 et 34, 36).

**4.** Système de puces selon la revendication 1, dans lequel l'étendue longitudinale la plus longue est celle de l'interface de transmission de signaux (18, 32) qui présente la densité volumique la plus importante.

**5.** Système de puces selon la revendication 1, dans lequel la deuxième puce (116, 124) repose au moins partiellement sur la première puce (114, 126).

**6.** Système de puces selon la revendication 2, dans lequel la première et la deuxième puce (70, 72) sont disposées l'une à côté de l'autre sur une surface de support.

**7.** Système de puces selon la revendication 5 ou 6, dans lequel une charge à constante diélectrique élevée est disposée entre la première et la deuxième interface de transmission de signaux (18 et 32) ou bien le cas échéant entre la première interface de transmission de signaux (18) et l'unité de couplage ainsi qu'entre la deuxième interface de transmission de signaux (32) et l'unité de couplage.

**8.** Système de puces selon l'une quelconque des revendications précédentes, dans lequel le nombre N2 d'éléments d'accouplement (20 à 30 ; 34, 36) de l'interface de transmission de signaux (18 ; 32) avec la densité volumique la plus importante présente un rapport, par rapport au nombre N1 d'éléments d'accouplement (20 à 30 ; 34, 36) de l'interface de transmission de signaux (18 ; 32) avec la densité volumique la moins importante, de N2 = g*N1+ X, g étant un chiffre supérieur à 1 et X étant le nombre d'éléments d'accouplement (20 à 30 ; 34, 36 ; 45 ; 46), lesquels se trouvent dans les segments longitudinaux en débordement de l'interface de transmission de signaux (18, 32) ou de l'unité de couplage le cas échéant.

**9.** Système de puces selon l'une quelconque des revendications précédentes, dans lequel l'interface de transmission de signaux (18 ; 32) de la puce formant un récepteur dans le flux des signaux entre la première et la deuxième puce est celle désignée comme étant la puce de réception (200) dans ce qui suit, laquelle présente des éléments d'accouplement d'une densité volumique plus importante.

**10.** Système de puces selon la revendication 9, avec un circuit de filtrage sur la puce de réception (200), lequel est couplé en aval de l'interface de transmission de signaux (18 ; 32), lequel circuit de filtrage est réalisé pour reconstruire des signaux envoyés par des éléments d'accouplement côté émission à l'aide des signaux réceptionnés par les éléments d'accouplement côté réception.

**11.** Système de puces selon la revendication 10, dans lequel le circuit de filtrage présente un certain nombre d'éléments de pondération (204), lesquels sont respectivement réalisés de manière à multiplier des signaux réceptionnés par plusieurs éléments d'accouplement côté réception par des facteurs de pondération variables, et de manière à additionner les signaux ainsi pondérés.

**12.** Système de puces selon la revendication 11, dans lequel des éléments d'accouplement côté réception sont connectés à plusieurs éléments de pondération (204).

**13.** Système de puces selon la revendication 11, dans lequel le nombre d'éléments de pondération (204) est égal au nombre des éléments d'accouplement prévus côté émission.

**14.** Système de puces selon la revendication 11, 12 ou 13, avec une unité de commande (210) connectée aux éléments d'accouplement et au circuit de filtrage, laquelle est réalisée de manière à déterminer les facteurs de pondération.

**15.** Système de puces selon la revendication 14, dans lequel l'unité de commande (210) est réalisée de manière à comparer, pour chaque élément de pondération (204), les signaux réceptionnés par les éléments d'accouplement côté réception connectés au filtre, respectivement à un modèle de signal prédéfini, et d'attribuer aux éléments d'accouplement respectivement un facteur de pondération dépendant du résultat de comparaison.

**16.** Système de puces selon la revendication 15, dans lequel l'unité de commande (210) est réalisée de manière à affecter, par élément de pondération (204), à un maximum d'un à trois éléments d'accouplement, un facteur de pondération différent de zéro de manière à ce que la somme de tous les facteurs de pondération soit de 1.

**17.** Système de puces selon l'une quelconque des revendications 10 à 16, dans lequel le circuit de filtrage présente, de manière additionnelle ou en variante, un certain nombre de bancs de filtrage (202), chaque banc de filtrage (202) étant connecté côté entrée à un certain nombre d'éléments d'accouplement.

**18.** Système de puces selon la revendication 17, dans lequel chaque banc de filtrage (202) présente un certain nombre de filtres, et chaque filtre étant connecté côté entrée à un élément d'accouplement.

**19.** Système de puces selon la revendication 18, dans lequel chaque filtre est réalisé de manière à émettre un signal de sortie, lequel dépend d'une somme pondérée du signal actuel et d'un certain nombre de signaux antérieurs dans le temps à son entrée.

**20.** Système de puces selon la revendication 17, dans lequel chaque filtre est réalisé de manière à déterminer son signal de sortie A en fonction de la formule suivante :

$$A(z) = \sum_{j=0}^{r} S(j) \cdot w(j, z),$$

S(j) étant un signal appliqué à une entrée de filtre selon une incrémentation temporelle J, r étant le nombre total des incrémentations temporelles prises en compte, w étant un facteur de pondération dépendant de l'incrémentation temporelle j respective, et z étant un indicateur désignant le filtre.

21. Système de puces selon la revendication 20, dans lequel le filtre présente une chaîne de retard des signaux avec r éléments de retard, r multiplicateurs et un additionneur, chacun des éléments de retard, et jusqu'au dernier d'entre eux, présentant en parallèle un multiplicateur et un élément de retard couplés en aval, seulement un multiplicateur étant couplé en aval du dernier élément de retard et les sorties des multiplicateurs étant connectées aux entrées parallèles de l'additionneur.

22. Système de puces selon les revendications 18 à 21, dans lequel chaque banc de filtrage (202) présente une unité de pondération (204), laquelle est réalisée pour multiplier des signaux réceptionnés par les filtres du banc de filtrage respectif (202) par des facteurs de pondération variables, et pour additionner les signaux ainsi pondérés.

23. Système de puces selon l'une quelconque des revendications 17 à 22, avec une unité de commande (210) connectée aux bancs de filtrage (202), laquelle est réalisée, lors d'une phase d'entraînement, pour soumettre les signaux appliqués aux éléments d'accouplement côté réception à une corrélation avec un ou plusieurs motifs de signaux connus, et pour déterminer, à l'aide du résultat de corrélation, les facteurs de pondération des filtres et du circuit de pondération (204).

24. Système de puces selon l'une quelconque des revendications précédentes, dans lequel la puce (90) dont l'interface de transmission de signaux présente un nombre moins important d'éléments d'accouplement, est celle qui présente respectivement un élément d'accouplement de bord ($A_{R1}$, $A_{R2}$) aux extrémités de son interface de transmission de signaux et est réalisée pour appliquer un signal de bord prédéfini aux éléments d'accouplement de bord ($A_{R1}$, $A_{R2}$).

25. Système de puces selon la revendication 1 ou 2, dans lequel la puce qui forme un émetteur dans le flux des signaux entre la première et la deuxième puce, est celle qui présente un circuit d'émission présentant des transistors CMOS complémentaires.

26. Système de puces selon la revendication 1 ou 2, dans lequel l'une des puces est un microprocesseur (130), l'autre puce étant une puce de mémoire (132).

27. Système de puces selon la revendication 1, avec une troisième puce, laquelle est couplée avec la première ou la deuxième puce de manière correspondante à celle décrite dans la revendication 1 ou la revendication 2 pour la transmission de signaux, de manière à ce que la première et/ou la deuxième puce est réalisée, pour le couplage avec la troisième puce, de la même manière que la première puce de la revendication 1 ou 2, et la troisième puce étant réalisée, pour le couplage avec la première puce, de la même manière que la deuxième puce de la revendication 1 ou 2, ou vis versa, la première ou la deuxième puce présentant une autre interface de transmission de signaux avec les caractéristiques de la première interface de transmission de signaux ou de la deuxième interface de transmission de signaux.

28. Système de puces selon la revendication 2, avec une troisième puce, laquelle est réalisée et disposée pour la transmission de signaux avec la première ou la deuxième puce d'une manière correspondante à la manière décrite dans la revendication 1 ou 2, la première ou la deuxième puce présentant une autre interface de transmission de signaux avec les caractéristiques de la première interface de transmission de signaux ou de la deuxième interface de transmission de signaux.

29. Procédé de fabrication d'un système de puces selon la revendication 2, avec les étapes suivantes :

    a) positionnement de la première puce sur un support,
    b) positionnement de la deuxième puce par rapport à la première puce sur le support,
    c) positionnement d'un module de couplage pour la réalisation d'un accouplement sans contact pour la transmission de signaux entre la première et la deuxième puce.

30. Procédé selon la revendication 29, avec une étape supplémentaire de détermination d'éléments d'accouplement actifs sur la puce avec un surnombre d'éléments d'accouplement par rapport à l'autre puce, de manière à déterminer, à l'aide de critères de signaux définis à l'avance, les éléments d'accouplement qui émettent un signal réceptionné.

EP 1 683 278 B1

40

20

22

24

26

28

30

18

11

I1

I12

I2

15

13

Chip 1

10

34

36

32

Chip2

12

Figur 1

Figur 2

EP 1 683 278 B1

Figur 3

EP 1 683 278 B1

24

44

Figur 4

EP 1 683 278 B1

Figur 5

44

46

47

45

24

EP 1 683 278 B1

541    Brücke    54    541    Leitend

502
Metall 6    501
Metall 5    522
521

Nicht-leitend

z

x

Chip A    Chip B

50    52

Figur 6

Horizontale Spule, Sender

Horizontale Spule, Empfänger

75

78

71

73

Chip A

Chip B

74

76

70 72

y

x

Figur 7

EP 1 683 278 B1

Metall 6
Metall 5
Metall 4
Metall 3
Metall 2
Metall 1

71

Chip A

70 72

Chip B

73

76

z

x

Figur 8

EP 1 683 278 B1

Figur 9

Figur 10

EP 1 683 278 B1

Figur 11

Figur 12

Figur 13

EP 1 683 278 B1

Figur 14

0.5-1kbit

50-400 Gbit/s

134 — DRAM ← → SRAM — 132

1-2 kbit

142    100-800 Gbit/s

140

Prozessor

I/O — 138    I/O — 136

130

Figur 15

EP 1 683 278 B1

Eingänge 1 bis N*g+X für N nutzbare Kanäle
(z.B. N=100, g=2.0, X=20: Eingänge 1 bis 220)

200

1   2   ......   N+X

M Eingänge zum Erzeugen von Kanal 1
(z.B. Eingänge 1 bis 30)

M Eingänge zum Erzeugen von Kanal 2
(z.B. Eingänge 3 bis 32)

M Eingänge zum Erzeugen von
Kanal 100 (z. B. Eingänge 191 bis 220)

Filter 1  1  2  ......  M(z.B. M=30)

Filter 2  1  2  ......  M(z.B. M=30)

202

Filter N  1  2  ......  M (z. B. M=30)

1  2  ......  M

1  2  ......  M

202

1  2  ......  M

Koeffizienten 1

202

Koeffizienten 2

......

Koeffizienten N

204

204

204

Ausgang 1   204

Ausgang 2

Ausgang N
(z. B. 100)

Ausgänge 1 bis N (z.B. N=100)

Steuereinheit (z.B. Signalprozessor)

......

A-priori-Wissen

208

206

*und/oder*

Vergleichseinheit

Koeffizenten-
Schätzer

210

Information über Daten

Figur 16

**IN DER BESCHREIBUNG AUFGEFÜHRTE DOKUMENTE**

**In der Beschreibung aufgeführte Patentdokumente**

- US 6496889 B1

**In der Beschreibung aufgeführte Nicht-Patentliteratur**

- **K. Kanda ; D. D. Antono ; K. Ishida ; H. Kawaguchi ; T. Kuroda ; T. Sakurai.** 1.27-Gbps/pin, 3mW/pin Wireless Superconnect (WSC) Interface Scheme. *IEEE ISSCC Digest of Technical Papers,* Februar 2003, 186-187
- **D.B. Salzman ; T.F. Knight.** Capacitively Coupled Multichip Modules. *Proceedings of the 1994 International Conference on Multichip Modules,* April 1994, 487-494
- **D. Salzman ; T. Knight.** Capacitive coupling solves the known good die problem. *Proceedings of the 1994 Multi-Chip Module Conference,* 1994, 95-100
- **D.B. Salzman ; T.F. Knight.** Manufacturability of capacitively coupled multichip modules. *IEEE Transactions onComponents, Packaging, and Manufacturing Technology, Part B: Advanced Packaging,* Mai 1995, vol. 18 (2), 277-281
- **D. Salzman ; T. Knight ; P. Franzon.** Application of capacitive coupling to switch fabrics. *Proceedings of the 1995 Multi-Chip Module Conference,* 1995, 195-199
- **S. Mick ; J. Wilson ; P. Franzon.** 4 Gbps High-Density AC Coupled Interconnection. *IEEE 2002 CICC Digest of Technical Papers,* Mai 2002
- **K. Kanda ; D. D. Antono ; K. Ishida ; H. Kawaguchi ; T. Kuroda ; T. Sakurai.** 1.27-Gbps/pin, 3mW/pin Wireless Superconnect (WSC) Interface Scheme. *IEEE ISSCC Digest of Technical Papers,* 2003, 186-187
- **Robert J. Drost et al.** Proximity Communication. *Proceedings of IEEE,* 2003, 469-472